# EUROPEAN PATENT SPECIFICATION

(11) **EP 0 591 786 B1**
(45) Date of publication and mention of the grant of the patent: **15.05.1996**
(21) Application number: 93115453.8
(22) Date of filing: 24.09.1993
(51) Int. Cl.: G03F 7/031, G03F 7/029

(54) **Photosensitive composition**
Lichtempfindliche Zusammensetzung
Composition photosensible

(30) Priority: 29.09.1992 JP 259915/92
(43) Date of publication of application: 13.04.1994
(73) Proprietor: FUJI PHOTO FILM CO., LTD., Kanagawa-ken (JP)
(72) Inventor: Miyake, Hideo, c/o FUJI PHOTO FILM CO., LTD., Haibara-gun, Shizuoka-ken (JP); Kurita, Hiromichi, c/o FUJI PHOTO FILM CO., LTD., Haibara-gun, Shizuoka-ken (JP); Shiraishi, Yuichi, c/o FUJI PHOTO FILM CO., LTD., Haibara-gun, Shizuoka-ken (JP); Kawamura, Koichi, c/o FUJI PHOTO FILM CO., LTD., Haibara-gun, Shizuoka-ken (JP)
(74) Representative: Grünecker, Kinkeldey, Stockmair & Schwanhäusser Anwaltssozietät

(56) References cited:
- US-A- 4 399 211
- US-A- 5 202 221
- PATENT ABSTRACTS OF JAPAN vol. 017, no. 461 (P-1598)23 August 1993 & JP-A-05 107 758 (FUJI PHOTO FILM CO., LTD.) 30 April 1993

## Description

The present invention relates to a photosensitive composition comprising (a) a photo-crosslinkable polymer capable of being crosslinked by a photo-dimerization reaction and (b) a new sensitizer, and in particular to a photosensitive composition useful for materials such as a photosensitive layer of a photosensitive lithographic printing plate and a photoresist.

Photo-crosslinkable materials which can be crosslinked by a photo-dimerization reaction are well-known. These materials are used, as a main component, in photosensitive compositions which are used for the production of, for example, photosensitive lithographic printing plates and photoresists. Those photo-crosslinkable polymers include polymers having a maleinimide group in a side chain and polymers having, in a side chain or a main chain, a cinnamyl group, a cinnamylidene group or a chalcone group which contains a photo-dimerizable unsaturated double bond adjacent to an aromatic nucleus. In particular, polymers having a maleinimide group are useful because they have a high sensitivity.

Photo-crosslinkable polymers do not have sufficient photosensitivity in a practical point of view. In order to increase the photosensitivity of the polymers, there have been used a sensitizer such as thioxanthones, benzophenone, Michler's ketone, anthraquinones, anthracene, cresene, p-dinitrobenzene, 2-nitrofluorenone, etc. These sensitizers can indeed increase the sensitivity of the photo-crosslinkable polymers, but the increase in sensitivity is still insufficient. Accordingly, imagewise exposure requires a long period of time for image formation, which leads to bad workability. When fine image is to be reproduced, good image cannot be obtained because slight vibration in the operation adversely affects the reproduction. In order to resolve this problem, there has been proposed in Japanese Unexamined Published Application (hereinafter referred to as "J.P. Kokai") No. Sho 62-294238, a sensitizer having the following formula: 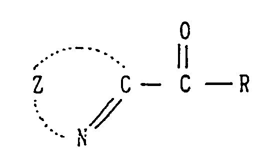 wherein Z is a group of non-metal atoms necessary for forming a heterocyclic ring nucleus containing a nitrogen atom; and R is a (substituted) aryl group or a (substituted) heterocyclic ring.

However, the sensitivity of the photo-crosslinkable polymers could not be sufficiently increased even with such sensitizers.

In order to resolve the above problem, there has also been proposed in U.S. Patent No. 5,202,221, a sensitizer having the following formula: 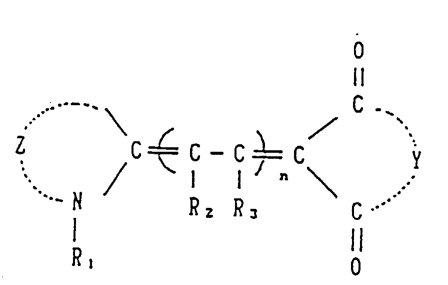 wherein Z is a group of non-metal atoms necessary for forming a heterocyclic ring nucleus containing a nitrogen atom; Y is a group of non-metal atoms necessary for forming a ring; R₁ is an alkyl group or a substituted alkyl group; R₂ and R₃ are independently a hydrogen atom, an alkyl group, a substituted alkyl group, an aryl group, a substituted aryl group, or a halogen atom; and n is an integer of 0-4.

These sensitizers can provide a relatively good sensitivity and photosensitive lithographic printing plates using such sensitizers have practically good performance.

However, when such lithographic printing plates using such sensitizers are developed with a developer containing substantially no organic solvent, there appears a new problem that insolubles accumulate in the developing bath. The insolubles cause the malfunction of the autodeveloper and deposit on the printing plate. In order to avoid this problem, it is necessary to often change the developing solution, which is a big problem in light of economy and resource utilization.

### SUMMARY OF THE INVENTION

The object of the present invention is to provide a photosensitive composition which is highly soluble in a developing solution containing substantially no organic solvent.

The present inventors have made intensive studies to achieve the foregoing object and, as a result, have found that a photosensitive composition containing the sensitizer having the following formula (I) has a high solubility to a developing solution which does not substantially contain an organic solvent. The present invention has been made on the basis of this finding. 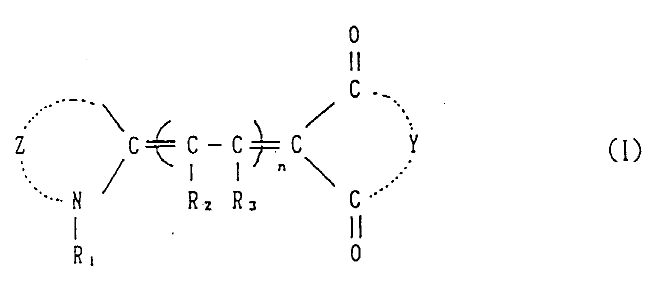 wherein
Z is a group of non-metal atoms necessary for forming a heterocyclic ring nucleus containing a nitrogen atom; Y is a group of non-metal atoms necessary for forming a ring;
R₁ is an alkyl group or a substituted alkyl group;
R₂ and R₃ are independently a hydrogen atom, an alkyl group, a substituted alkyl group, an aryl group, a substituted aryl group, or a halogen atom:
at least one of Z, Y and R₁ contains at least one group selected from the group consisting of -COOH, -NHSO₂R₄, CONHCOR₄ and CONHSO₂R₄;
R₄ is an alkyl group, an aromatic group or an aromatic alkyl group; and
n is an integer of 0-4.

The present invention relates to a photosensitive composition comprising:
(a) a photo-crosslinkable polymer having a photo-dimerizable unsaturated double bond, and
(b) a sensitizer having the formula (I) above.

The present invention will be explained in detail below.

The photo-crosslinkable polymer having a photo-dimerizable unsaturated bond and being used in the present photosensitive composition includes photosensitive polymers containing, in a side chain or a main chain, a functional group such as a maleinimide group, a cinnamyl group, a cinnamoyl group, a cinnamylidene group or a chalcone group. In particular, polymers containing a maleinimide group are preferable since they have a relatively high sensitivity.

The photo-crosslinkable polymers containing a maleinimide group include those polymers containing a maleinimide group having the following formula (A) in a side chain. 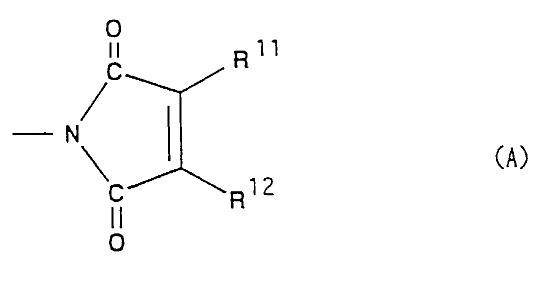 wherein
R¹¹ and R¹ are independently a hydrogen atom, a halogen atom or an alkyl group, and they may be combined to form a five-membered or six membered ring. The alkyl group as R¹¹ and R¹ preferably those alkyl groups having 1-4 carbon atoms, especially a methyl group. It is also preferable that R¹¹ and R¹ be combined to form a six-membered ring. The halogen atom is preferably a chlorine atom, a bromine atom and an iodine atom.

Those polymers are described, for example, in J.P. Kokai No. Sho 52-988 (corresponding to U.S. Patent No. 4,079,041), West German Patent No. 2,626,769, European Patent Nos. 21,019 and 3,552, pages 163-181 of Die Angewandte Makromolekulare Chemie, 115 (1983), J.P. Kokai Nos. Sho 49-128991 to 49-128993, 50-5376 to 50-5380, 53-5298 to 53-5300, 50-50107, 51-47940, 52-13907, 50-45076, 52-121700, 50-10884, 50-45087, 58-43951 etc., West German Patent Nos. 2,349,948 and 2,616,276. In the present invention, the photo-crosslinkable polymer is preferably those polymers having, in a side chain, two or more maleinimide groups per molecule on an average and also having an average molecular weight of 1, 000 or higher, Such polymers can be easily prepared by copolymerizing a monomer having the following formulae (B) to (E) with a monomer having an alkaline-soluble group in a molecule, at a ratio of, for example, 95/5 to 30/70, preferably 90/10 to 50/50 (molar ratio). 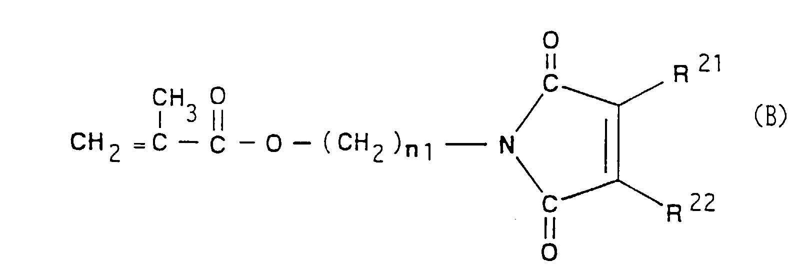 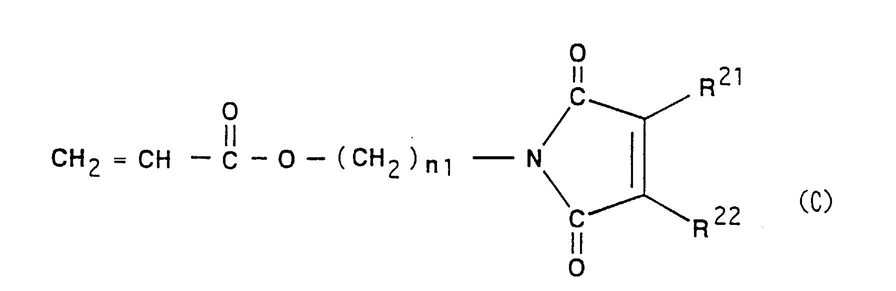 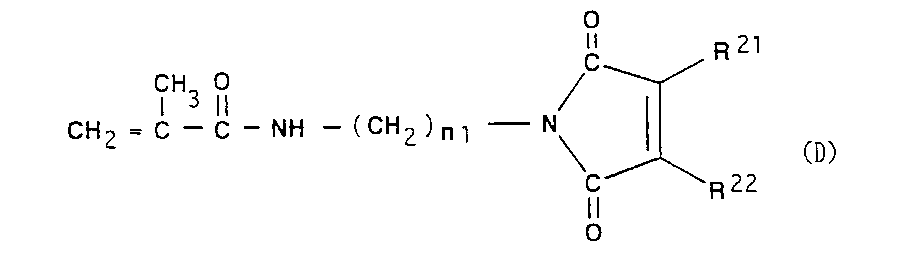 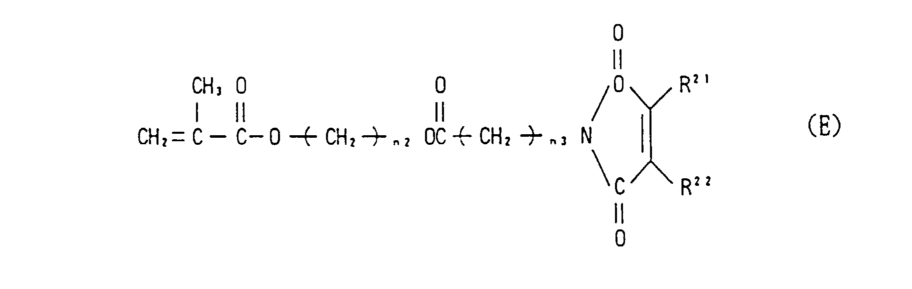 wherein R¹ and R are the same as R¹¹ and R¹ defined above; and n₁, n ₂ and n₃ are an integer, preferably an integer of 1-6.

More specifically, the polymers having an alkaline-soluble group are preferable because an alkaline water can be used for the development and they are advantageous in an environmetal point of view. The acid value of the maleinimide polymers having the alkaline-soluble group is preferably 9-265, much preferably 20-150. Monomers having an alkaline-soluble group in a molecule include vinyl monomers having a carboxylic group such as acrylic acid and methacrylic acid, vinyl monomers having a -CONHSO₂- group as described by the following formula (F) below, vinyl monomers having an -SO₂NH₂ group as described by the following formula (G), vinyl monomers having a phenolic hydroxide group as described by the following formula (H), vinyl monomers having a phosphoric acid or phosphonic acid group as described by the following formula (J), a maleic anhydride, and an itaconic anhydride. In case where the anhydride is used, hydrolysis is necesssary. 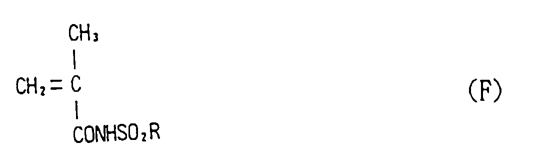 (R: a methyl group, a phenyl group, a tolyl group, etc.) 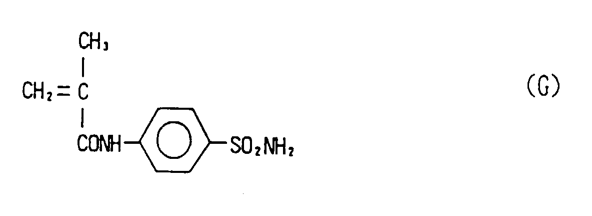 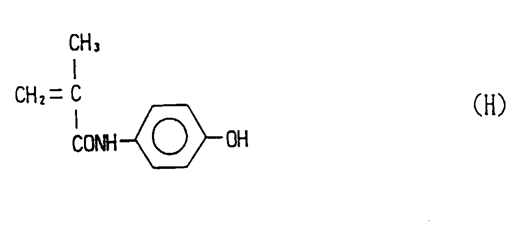 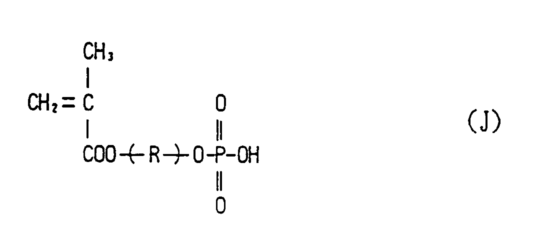 (R: -(CH₂)ₙ -, a phenylene group, etc.)

Among these polymers, the photo-crosslinkable polymers used in the present photosensitive composition are preferably those copolymers of N-(2-methacryloyloxyethyl)-2,3-dimethylmaleinimide and methacrylic or acrylic acid (i.e., a vinyl monomer having an alkaline-soluble group) as disclosed in pages 71-91 of Die Angewandte Makromolekulare Chemie, 128 (1984). Such photo-crosslinkable polymers may be multi-component copolymers produced by further using other vinyl monomers than the above vinyl monomer.

The average molecular weight of the photo-crosslinkable polymers used in the present photosensitive composition is 1000 to 1,000,000, preferably 10,000 to 500,000, much preferably 20,000 to 300,000.

The photo-crosslinkable polymers are used in an amount of 10-99 wt.%, preferably 50-99 wt.%, based on the total weight of the present photosensitive composition.

The sensitizer having the formula (I) usable in the present photosensitive composition will be explained in detail below.

In the formula (I) representing the sensitizer usable in the present photosensitive composition, Z is a group of non-metal atoms necessary for forming a heterocyclic ring nucleus containing a nitrogen atom as used in a conventional cyanine dye. At least one of Z, Y and R₁ contains at least one group selected from the group consisting of - COOH, -NHSO₂R₄, CONHCOR₄ and CONHSO₂R₄ (R₄ is an alkyl group, an aromatic group or an alkyl aromatic group). The alkyl group as R₄ represents those alkyl groups having a carbon number of generally 1-20, preferably 1-14, much preferably 1-8. The aromatic group as R₄ represents those aromatic groups having a carbon number of generally 6-20, preferably 6-14 much preferably 6-10. Among them, a COOH group is preferable, in view of solubility.

The heterocyclic ring nucleus containing Z and a nitrogen atom includes benzothiazoles (e.g., benzothiazole, 5-carboxy-benzothiazole, 6-carboxy-benzothiazole, 5-carboxyethyl-benzothiazole, 5-chlorobenzothiazole, 6-chlorobenzothiazole, 4-carboxy-5-chlorobenzothiazole, 4-carboxy-6-chlorobenzothiazole, 4-carboxyethyl-5-chlorobenzothiazole, 5-carboxypropyl-6-chlorobenzothiazole, 4-methylbenzothiazole, 5-methylbenzothiazole, 5-carboxy-4-methylbenzothiazole, 6-carboxy-5-methylbenzothiazole, 5-carboxyethyl-4-methylbenzothiazole, 6-carboxymethyl-5-methylbenzothiazole, 6-carboxyethyl-5-ethylbenzothiazole, 6-carboxypropyl-5-ethylbenzothiazole, 5-phenylbenzothiazole, 5-(4-carboxyphenyl)-benzothiazole, 4-carboxy-5-phenylbenzothiazole, 5-carboxyethyl-6-phenylbenzothiazole, 6-ethoxybenzothiazole, 6-methoxybenzothiazole, 5-carboxy-6-methoxybenzothiazole, 4-carboxy-5-methoxybenzothiazole, 4-carboxymethyl-5-methoxybenzothiazole, 5-carboxy-6-ethoxybenzothiazole, 4-carboxyethyl-5-ethoxybenzothiazole, 5-hydroxybenzothiazole, 6-hydroxybenzothiazole, 6-carboxy-5-hydroxybenzothiazole. 6-carboxymethyl-5-hyd roxybenzothiazole, 5-carboxyethyl-6-hydroxybenzothiazole, 5-carboxypropyl-6-hydroxybenzothiazole, 5,6-dihydroxybenzothiazole, 5,6-dimethoxybenzothiazole, 4-carboxy-5,6-dimethoxybenzothiazole, 5,6-dimethylbenzothiazole, 4-carboxy-5,6-dimethylbenzothiazole, etc.); naphthothiazoles (e.g., α-naphthothiazole, β-naphthothiazole, 4-carboxy-α-naphthothiazole, 4-carboxy-β-naphthothiazole, 5-carboxy-α-naphthothiazole, 5-carboxymethyl-β-naphthothiazole, 6-carboxyethyl-α -naphthothiazole, 6-carboxypropyl-β-naphthothiazole, etc.); benzoselenazoles (e,g., benzoselenazole, 4-carboxymethylbenzoselenazole, 5-chlorobenzoselenazole, 4-carboxy-benzoselenazole, 5-carboxy-benzoselenazole, 6-carboxy-benzoselenazole, 4-carboxy-5-chlorobenzoselenazole, 6-carboxymethyl-5-chlorobenzoselenazole, 5-carboxyethyl-6-chlorobenzoselenazole, 5-carboxypropyl-6-chlorobenzoselenazole, 6-methylbenzoselenazole, 5-carboxybenzoselenazole, 4-carboxy-5-methylbenzoselenazole, 6-carboxymethyl-5-methylbenzoselenazole, 6-carboxyethyl-5-methylbenzoselenazole, 6-methoxybenzoselenazole, 5-carboxy-6-methoxybenzoselenazole, 5-carboxymethylbenzoselenazole, 6-carboxyethyl-5-methoxybenzoselenazole, 7-carboxypropyl-6-methoxybenzoselenazole, etc.); naphthoselenazoles (e.g., α-naphthoselenazole, β-naphthoselenazole, 5-carboxy-α-naphthoselenazole, 6-carboxy-α-naphthoselenazole, 7-carboxy-α-naphthoselenazole, 8-carboxy-α-naphthoselenazole, 5-carboxynethyl-α-naphthoselenazole, 6-carboxyethyl-α-naphthoselenazole, 7-carboxypropyl-α-naphthoselenazole, 8-carboxypropyl-α-naphthoselenazole, 5-carboxy-β-naphthoselenazole, 6-carboxy-β-naphthoselenazole, 7-carboxy-β-naphthoselenazole, 8-carboxy-β-naphthoselenazole, 5-carboxymethyl-β-naphthoselenazole, 6-carboxyethyl-α-naphthoselenazole, 7-carboxypropyl-β-naphthoselenazole, 8-carboxypropyl-β-naphthoselenazole, etc.); benzoxazoles (e.g., benzoxazole, 4-carboxybenzoxazole, 5-carboxybenzoxazole, 6-carboxybenzoxazole, 7-carboxybenzoxazole, 4-carboxy-5-methylbenzoxazole, 5-carboxy-6-methylbenzoxazole, 4-carboxymethyl-6-methylbenzoxazole, 5-carboxyethyl-6-ethylbenzoxazole, 5-phenylbenzoxazole, 5-(p-carboxyphenyl)benzoxazole, 4-carboxy-5-phenylbenzoxazole, 6-carboxypropyl-5-phenylbenzoxazole, 6-methoxybenzoxazole, 5-carboxy-6-methoxybenzoxazole, 5-carboxymethyl-6-methoxybenzoxazole, 7-carboxypropyl-6-methoxybenzoxazole, etc.); naphthoxazoles (e.g., α-naphthoxazole, 4-carboxy-α-naphthoxazole, 5-carboxy-α-naphthoxazole, 6-carboxy-α-naphthoxazole, 4-carboxymethyl-α -naphthoxazole, 5-carboxyethyl-α-naphthoxazole, 6-carboxypropyl-α-naphthoxazole, β-naphthoxazole, 4-carboxy-β-naphthoxazole, 5-carboxy-β-naphthoxazole, 6-carboxy- β-naphthoxazole, 7-carboxy-β-naphthoxazole, 8-carboxymethyl-β-naphthoxazole, 9-carboxypropyl-β-naphthoxazole, 6-carboxyethyl-β-naphthoxazole, etc.); imidazoles (e.g., imidazole, 4-carboxyimidazole, benzimidazole, 5-carboxybenzimidazole, etc.); isoindoles (e.g., 3,3-dimethylindolenine, etc.); quinolines (e.g., quinoline, isoquinoline, 3-carboxyquinoline, etc.); diazoles (e.g., 1,3, 4-oxadiazole, 1,3,4-thiadiazole, 1,3,4-selenadiazole, etc.); triazoles; pyrazines; quinoxalines; S-triazines; and phenanthridines.

Among those heterocyclic rings, benzothiazoles, naphthothiazoles, benzoxazoles, and naphthoxazoles are preferred. In particular, benzothiazoles and naphthothiazoles are much preferred as a heterocyclic ring.

Y is a group of non-metal atoms necessary for forming a ring. Such ring is, for example, those rings having the following formulae:

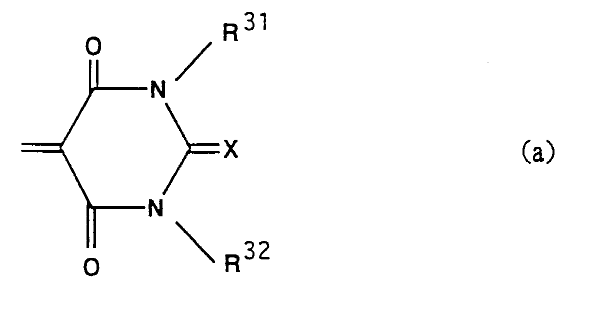

In the formula (a), R³¹ and R ³ independently represent a hydrogen atom, an alkyl group, a substituted alkyl group, an aryl group, a substituted aryl group, an allyl group, or a substituted allyl group: and X is an oxygen atom or a sulfur atom.

The alkyl group as R³¹ and R³ includes those having 1-20 carbon atoms, more preferably those having 1-14 carbon atoms, most preferably those having 1-8 carbon atoms.

The substituents of the substituted alkyl group as R³¹ and R³ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), - CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R³¹ and R³ is suitably those aryl groups having 6-20 carbon atoms, preferably 6-14 carbon atoms, most preferably 6-10 carbon atoms.

The substituents of the substituted aryl group as R³¹ and R³ include those substituents as defined in relation to the substituted alkyl group as well as an alkyl group having 1-5 carbon atoms.

The substituents of the substituted allyl group as R³¹ and R³ include an alkyl group having 1-5 carbon atoms.

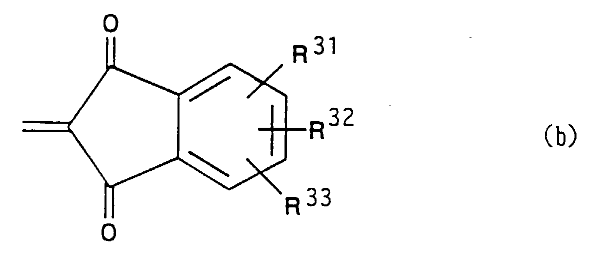

In the formula (b), R³¹, R ³ and R³³ independently represent a hydrogen atom, an alkyl group, a substituted alkyl group, an aryl group, a substituted aryl group, an allyl group, a substituted allyl group, an alkoxy group, a substituted alkoxy group, a nitro group, a cyano group, an amino group, or a halogen atom.

The alkyl group as R³¹, R ³ and R³³ includes those having 1-20 carbon atoms, more preferably those having 1-14 carbon atoms, most preferably those having 1-8 carbon atoms.

The substituents of the substituted alkyl group as R³¹, R ³ and R³³ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), -CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R³¹, R³ and R³³ is those having 6-20 carbon atoms, preferably 6-14 carbon atoms, most preferably 6-10 carbon atoms.

The substituents of the substituted aryl group as R³¹, R³ and R³³ include those substituents as defined in relation to the substituted alkyl group as well as an alkyl group having 1-5 carbon atoms.

The substituents of the substituted allyl group as R³¹, R³ and R³³ include an alkyl group having 1-5 carbon atoms.

The alkoxy group as R³¹, R³ and R³³ is suitably those alkoxy groups having 1-20 carbon atoms, preferably 1-14 carbon atoms, most preferably 1-8 carbon atoms.

The substituents of the substituted alkoxy group as R³¹, R³ and R³³ include an alkyl group having 1-5 carbon atoms, an aryl group such as a phenyl group, an alkenyl group having 2-5 carbon atoms such as a vinyl group or an allyl group, a halogen atom such as, Cl and Br, a hydroxy group, a cyano group, an alkoxy group having 1-5 carbon atoms such as a methoxy group and methoxyethoxy group, amino group such as - NH₂, -N(CH₃)₂, and an alkylcarbonyl group having 2-5 carbon atoms.

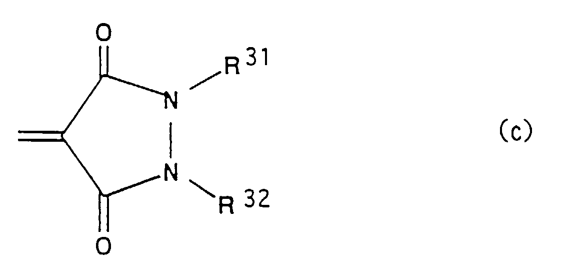

In the formula (c), R³¹ and R ³ independently represent a hydrogen atom, an alkyl group, a substituted alkyl group, an aryl group, a substituted aryl group, an allyl group or a substituted allyl group.

The alkyl group as R³¹ and R³ includes those having 1-20 carbon atoms, more preferably those having 1-14 carbon atoms, most preferably those having 1-8 carbon atoms.

The substituents of the substituted alkyl group as R³¹ and R³ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), - CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R³¹ and R³ is suitably those aryl groups having 6-20 carbon atoms, preferably 6-14 carbon atoms, most preferably 6-10 carbon atoms.

The substituents of the substituted aryl group as R³¹ and R³ include those substituents as defined in relation to the substituted alkyl group as well as an alkyl group having 1-5 carbon atoms.

The substituents of the substituted allyl group as R³¹ and R³ include an alkyl group having 1-5 carbon atoms.

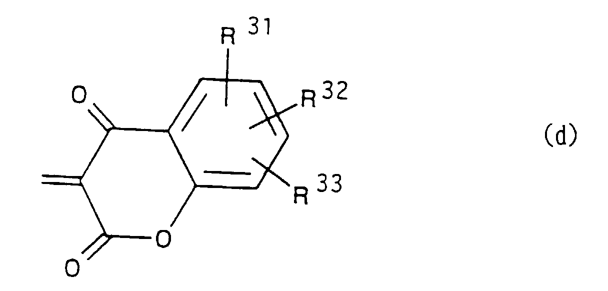

In the formula (d), R³¹, R ³ and R³³ independently represent a hydrogen atom, an alkyl group, a substituted alkyl group, an aryl group, a substituted aryl group, an allyl group, a substituted allyl group, an alkoxy group, a substituted alkoxy group, a nitro group, a cyano group, an amino group, or a halogen atom.

The alkyl group as R³¹, R ³ and R³³ includes those having 1-20 carbon atoms, more preferably those having 1-14 carbon atoms, most preferably those having 1-8 carbon atoms.

The substituents of the substituted alkyl group as R³¹, R ³ and R³³ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), -CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R³¹, R ³ and R³³ is those having 6-20 carbon atoms, preferably 6-14 carbon atoms, most preferably 6-10 carbon atoms.

The substituents of the substituted aryl group as R³¹, R ³ and R³³ include those substituents as defined in relation to the substituted alkyl group as well as an alkyl group having 1-5 carbon atoms.

The substituents of the substituted allyl group as R³¹, R³ and R³³ include an alkyl group having 1-5 carbon atoms.

The alkoxy group as R³¹, R³ and R³³ is suitably those alkoxy groups having 1-20 carbon atoms, preferably 1-14 carbon atoms, most preferably 1-8 carbon atoms.

The substituents of the substituted alkoxy group as R³¹, R³ and R³³ include an alkyl group having 1-5 carbon atoms, an aryl group such as a phenyl group, an alkenyl group having 2-5 carbon atoms such as a vinyl group or an allyl group, a halogen atom such as Cl and Br, a hydroxy group, a cyano group, an alkoxy group having 1-5 carbon atoms such as a methoxy group and methoxyethoxy group, amino group such as - NH₂, -N(CH₃)₂, and an alkylcarbonyl group having 2-5 carbon atoms.

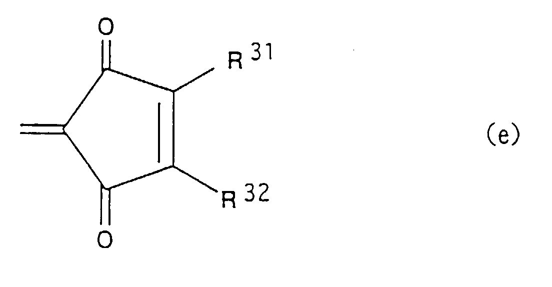

In the formula (e), R³¹ and R ³ independently represent a hydrogen atom, an alkyl group, a substituted alkyl group, an aryl group and a substituted aryl group.

The alkyl group as R³¹ and R³ includes those having 1-20 carbon atoms, more preferably those having 1-14 carbon atoms, most preferably those having 1-8 carbon atoms.

The substituents of the substituted alkyl group as R³¹ and R³ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), - CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R³¹ and R³ is suitably those aryl groups having 6-20 carbon atoms, preferably 6-14 carbon atoms, most preferably 6-10 carbon atoms.

The substituents of the substituted aryl group as R³¹ and R³ include those substituents as defined in relation to the substituted alkyl group as well as an alkyl group having 1-5 carbon atoms.

R₁ is an alkyl group which is known usually as a cyanine dye and represents a saturated or unsaturated and linear or branched alkyl group having 1-20 carbon atoms, preferably 1-8 carbon atoms, most preferably 1-4 carbon atoms or the substituted alkyl group thereof. The substituents of the substituted alkyl group include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), -CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), -CONHR (R is an alkyl group having 1-5 carbon atoms or an aryl group), -CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group). Such alkyl group includes a methyl group, an ethyl group, a propyl group, etc. The substituted alkyl group includes a 2-hydroxyethyl group, a 2-methoxyethyl group, a carboxymethyl group, a 2-carboxyethyl group, a 3-carboxypropyl group, a 2-sulfoethyl group, a 3-sulfopropyl group, a 2-carbomethoxy group, a benzyl group, a phenethyl group, a p-sulfophenethyl group, a p-carboxyphenethyl group, a vinylmethyl group, a CH₂CONHSO₂CH₃ group, a CH₂CONHSO₂C₆H₅ group, a CH₂NHSO₂CH₃ group and a CH₂CONHCOCH₃ group.

R₂ and R₃ independently represent a hydrogen atom, an alkyl group, a substituted alkyl group, an aryl group, a substituted ary group or a halogen atom.

The alkyl group as R₂ and R₃ includes those having 1-20 carbon atoms, more preferably those having 1-14 carbon atoms, most preferably those having 1-8 carbon atoms.

The substituents of the substituted alkyl group as R₂ and R₃ include a halogen atom such as Cl, Br and I, a carboxy group, a hydroxy group, a cyano group, a nitro group, -CHO, a sulfo group, an aryl group such as a phenyl group, a tolyl group and a 2-naphthyl group, -CONHCOR (R is an alkyl group having 1-5 carbon atoms or an aryl group), - CONHSO₂R (R is an alkyl group having 1-5 carbon atoms or an aryl group), -NHSO₂R (R is an alkyl group having 1-5 carbon atoms or an aryl group), -COR (R is an alkyl group having 1-5 carbon atoms or an aryl group), - CONHR (R is an alkyl group having 1-5 carbon atoms or an aryl group), - CON(R)₂ (R is an alkyl group having 1-5 carbon atoms or an aryl group), an alkoxy group having 1-5 carbon atoms, an amino group, an alkylamino group wherein the alkyl group has 1-3 carbon atoms, and -COOR (R is an alkyl group having 1-5 carbon atoms or an aryl group).

The aryl group as R₂ and R₃ is suitably those aryl groups having 6-20 carbon atoms, preferably 6-14 carbon atoms, most preferably 6-10 carbon atoms.

The substituents of the substituted aryl group as R₂ and R₃ include those substituents as defined in relation to the substituted alkyl group as well as an alkyl group having 1-5 carbon atoms.

The substituents of the substituted allyl group as R₂ and R₃ include an alkyl group having 1-5 carbon atoms.

n is an integer of 0-4.

The sensitizer having the formula (I) can be generally produced by known methods. The representative methods are described in, for example, T. H. James, "The Theory of Photographic Process", 4th ed., published by Macmillan Co., New York (1971) and F. M. Hamer, "The Cyanine Dyes and Related Compounds" published by John Wiley & Sons Co., New York (1964).

The representative examples of the sensitizers are as follows. In this case, R⁴¹ is -CH₂COOH, -CH₂CH₂COOH, -CH₂CH₂CH₂COOH or - CH₂CH₂CH₂CH₂COOH. R⁴ is -COOH, -CH₂COOH, -CH₂CH₂COOH, -CH₂CH₂CH₂COOH or -CH₂CH₂CH₂CH₂COOH.

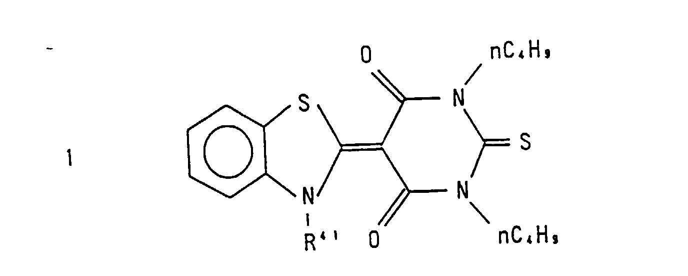

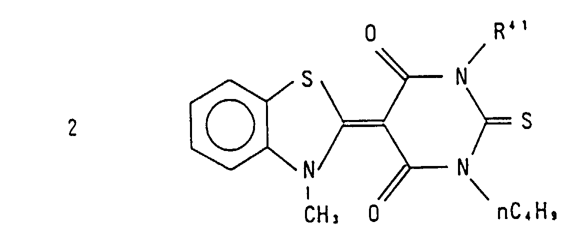

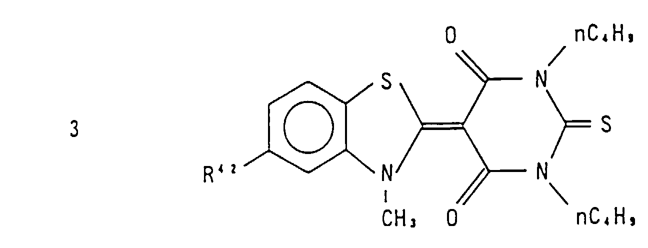

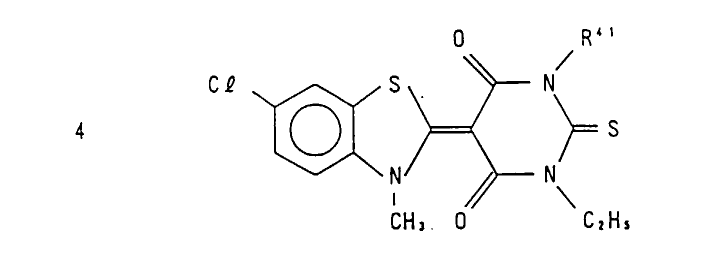

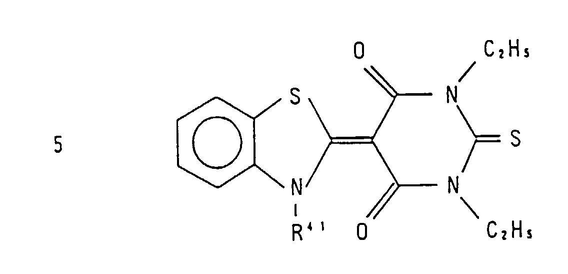

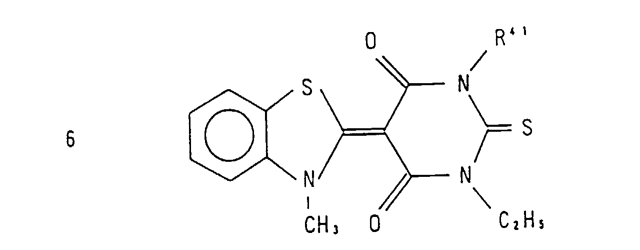

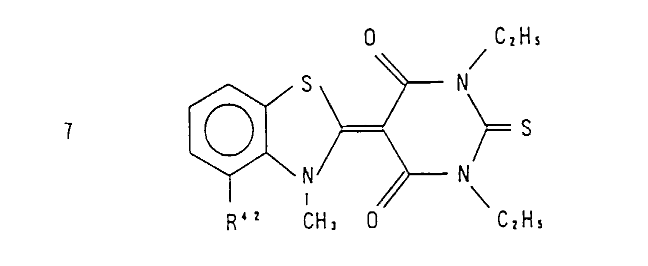

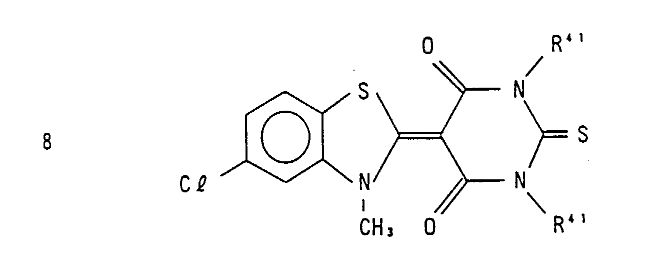

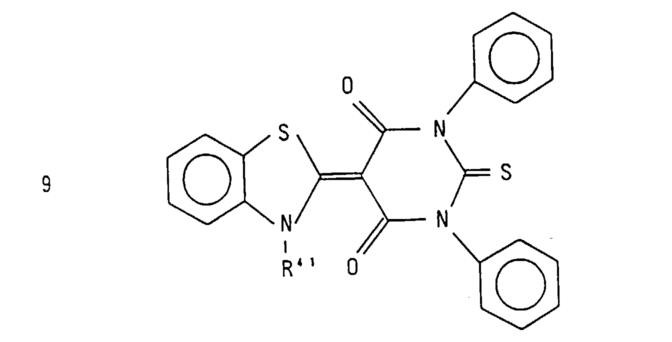

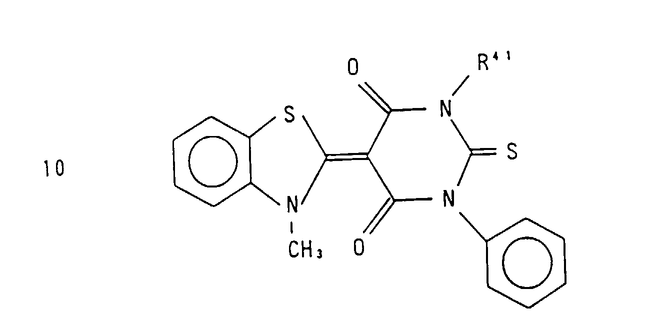

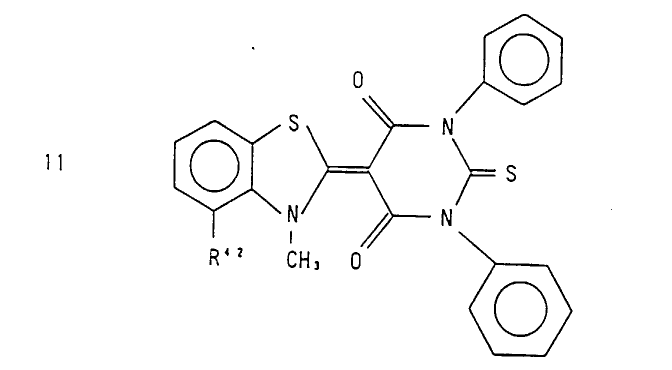

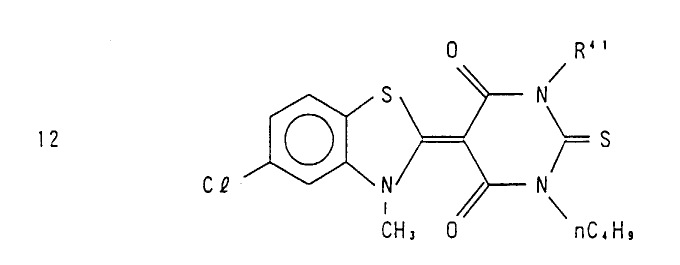

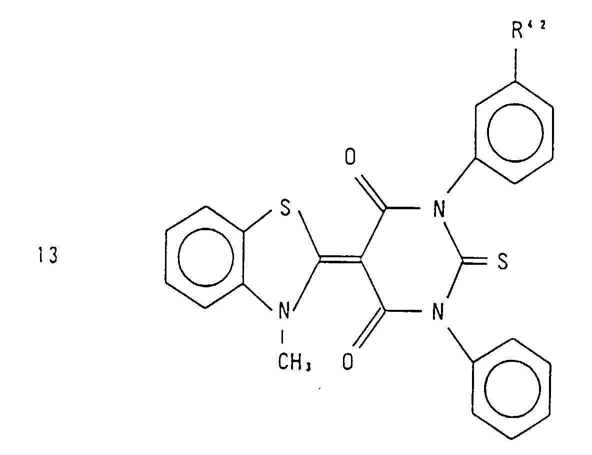

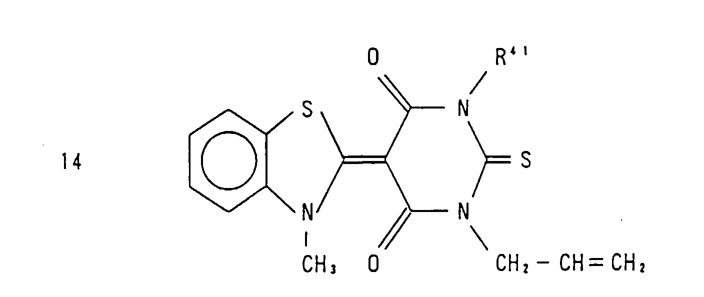

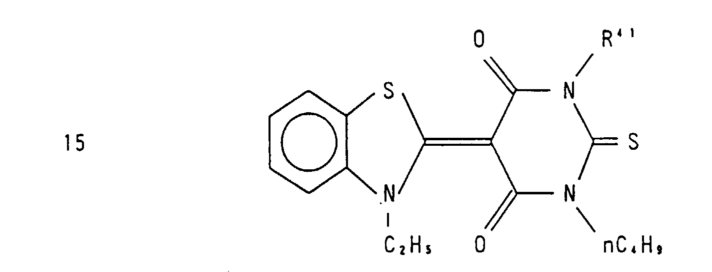

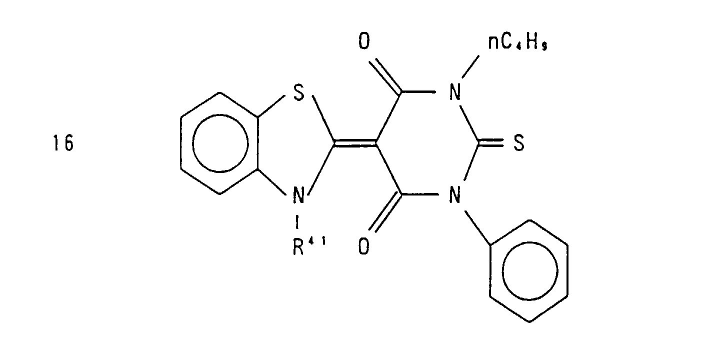

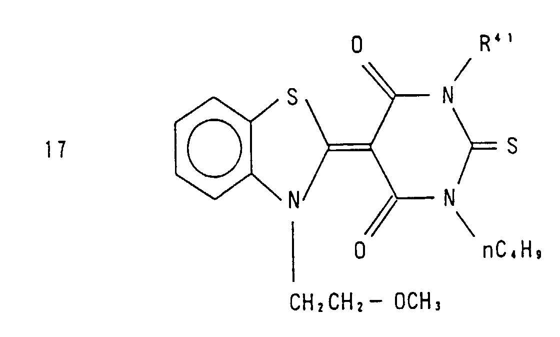

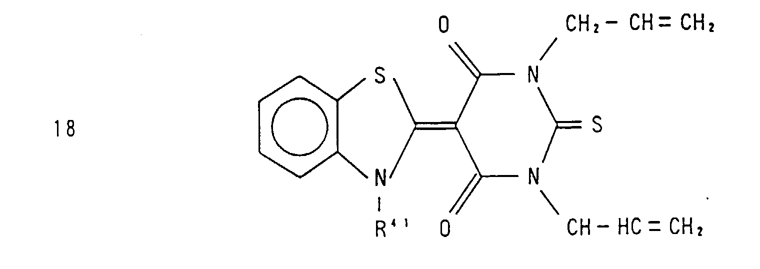

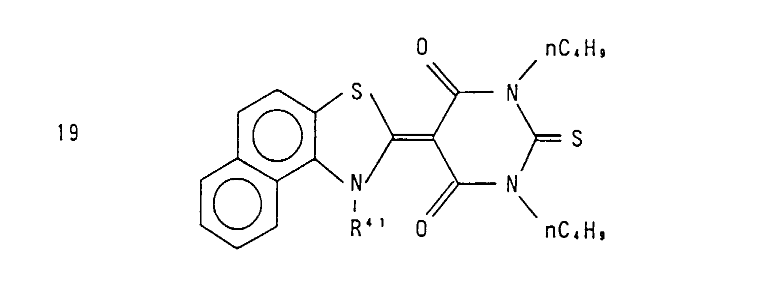

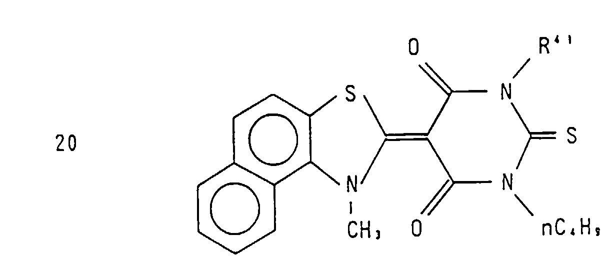

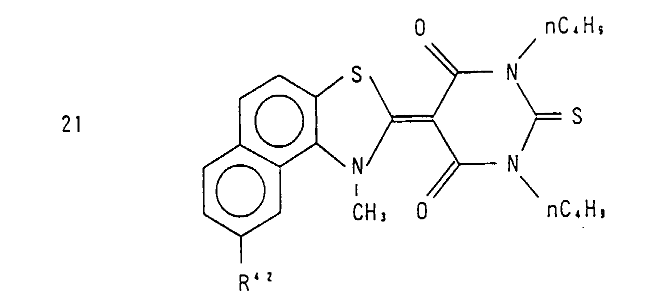

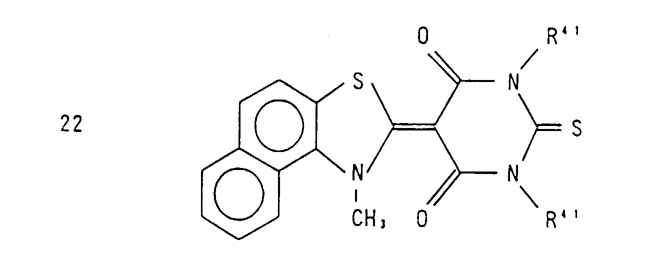

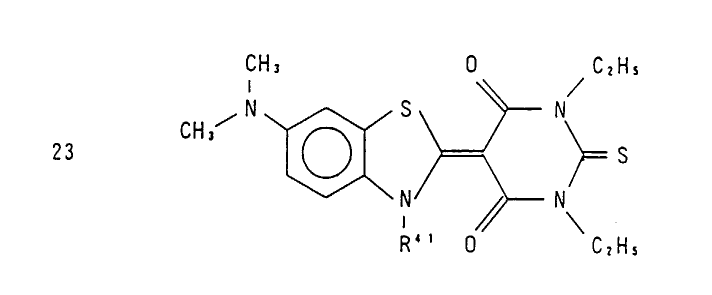

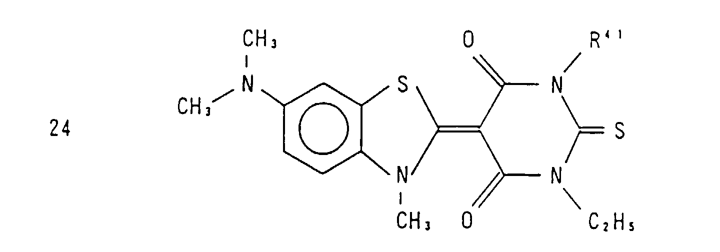

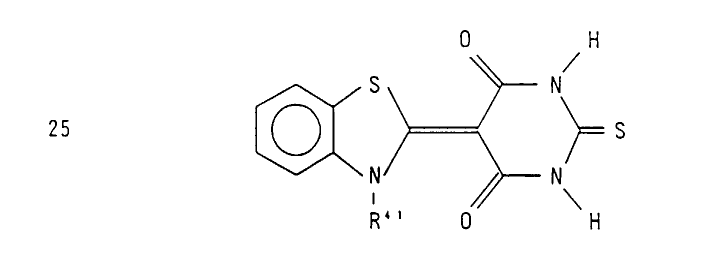

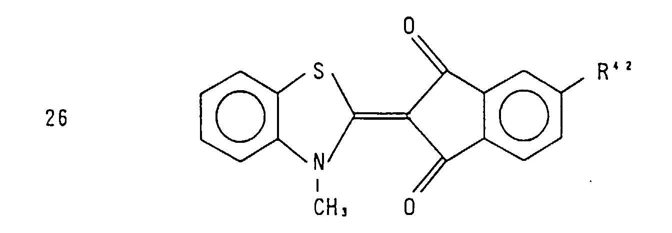

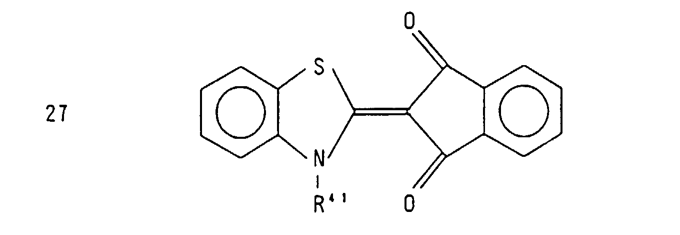

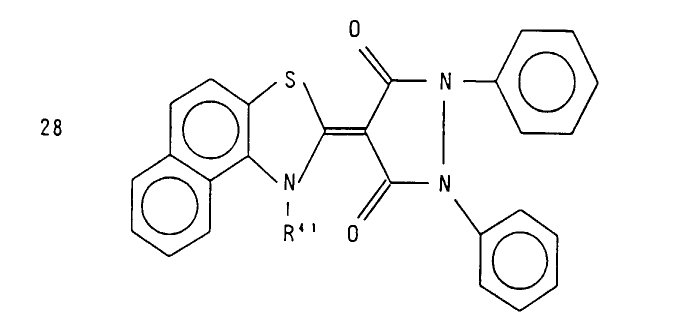

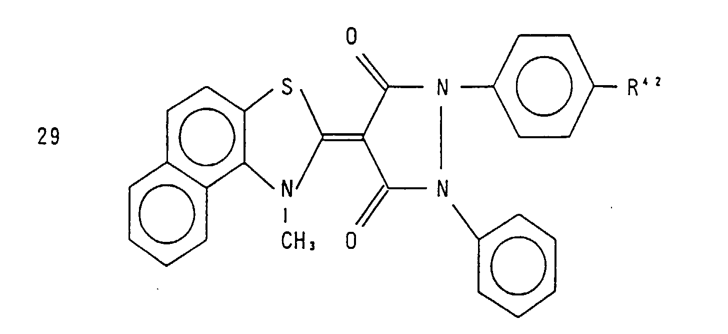

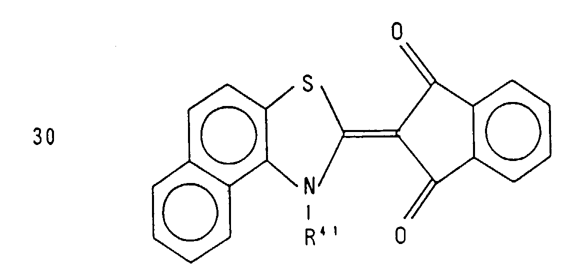

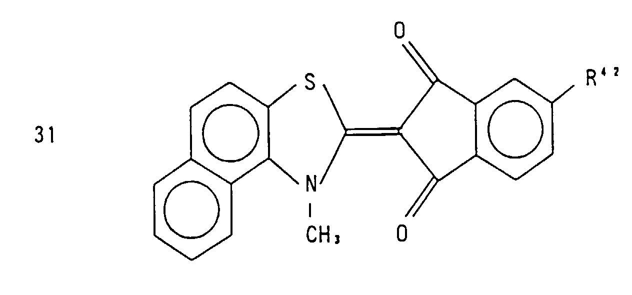

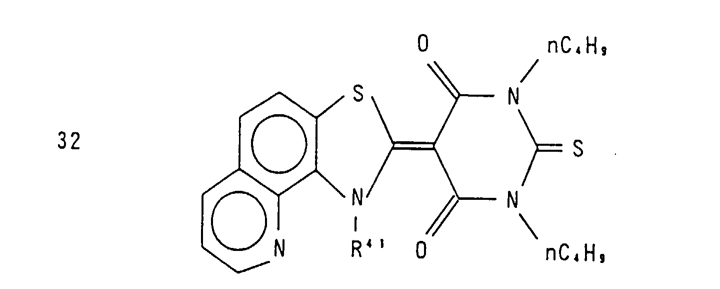

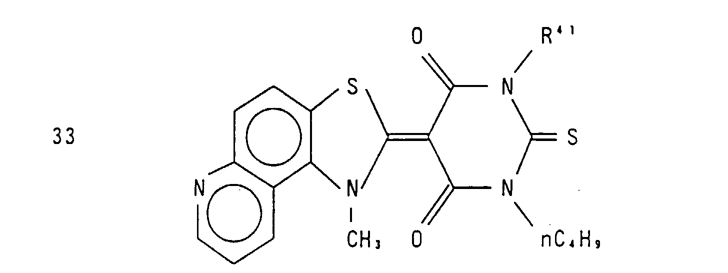

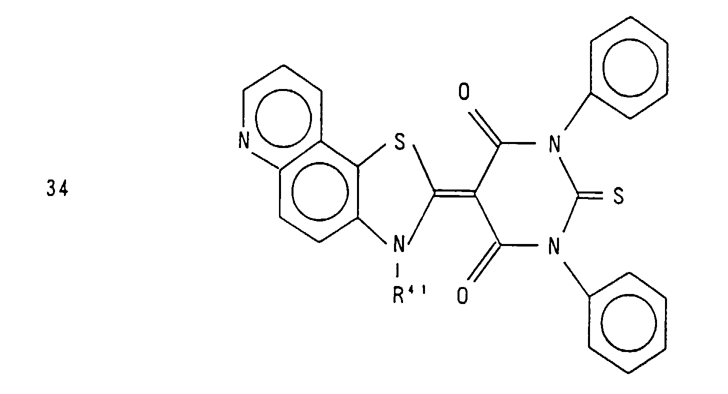

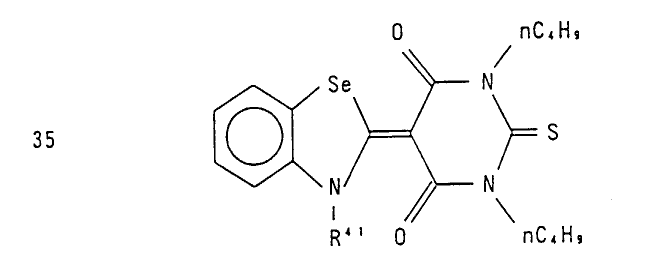

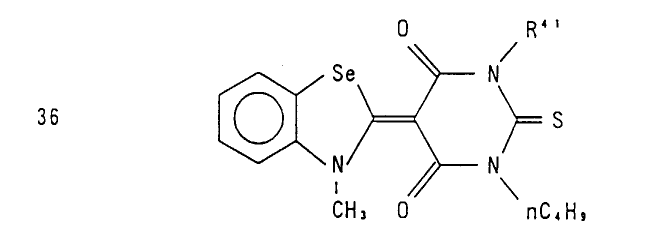

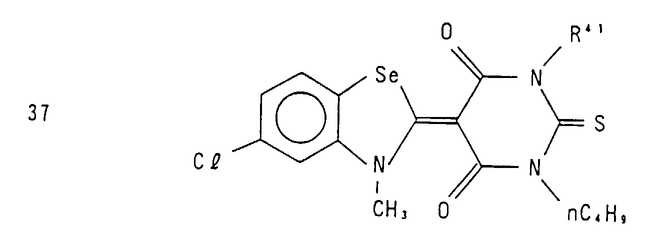

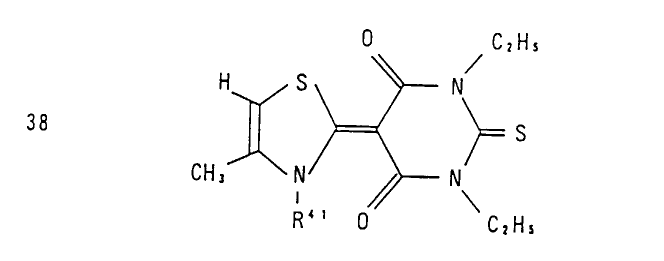

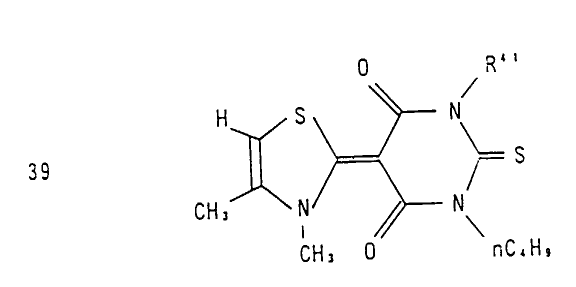

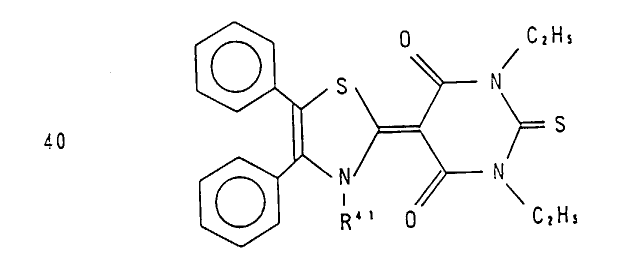

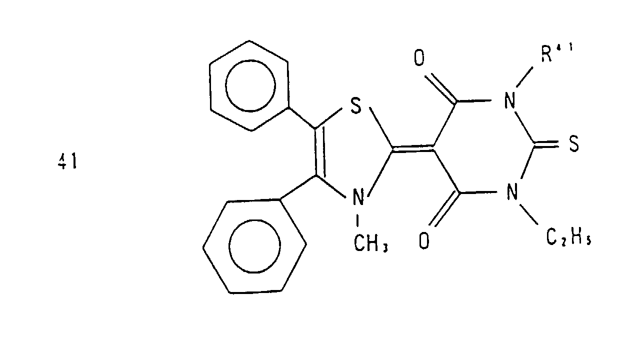

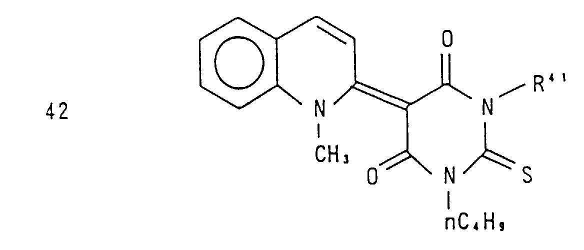

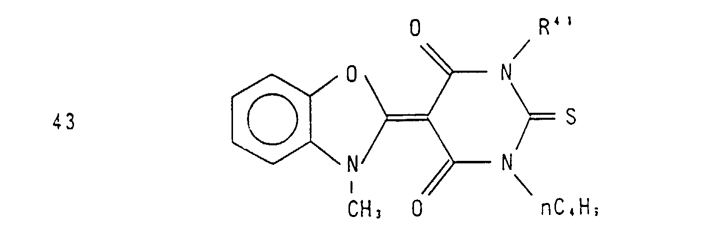

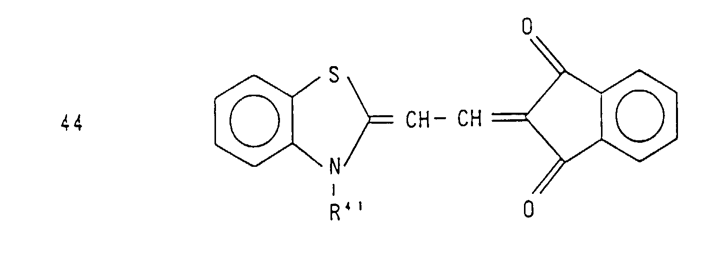

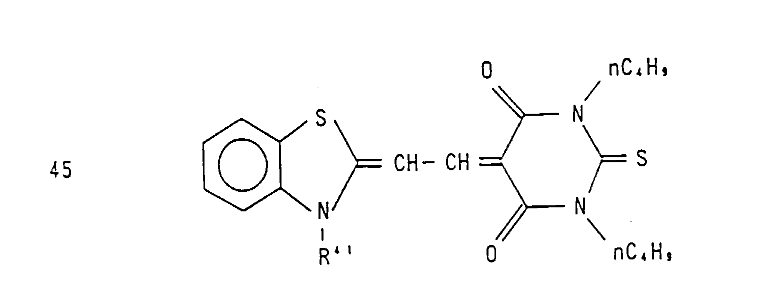

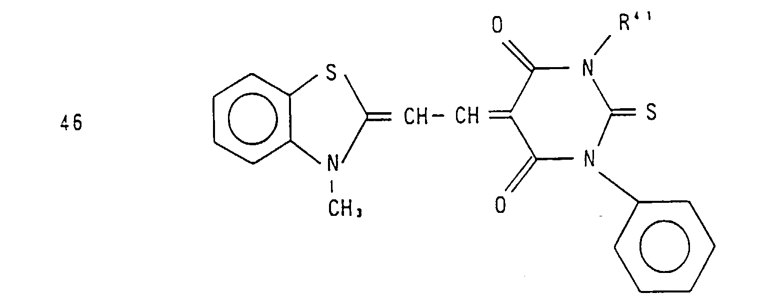

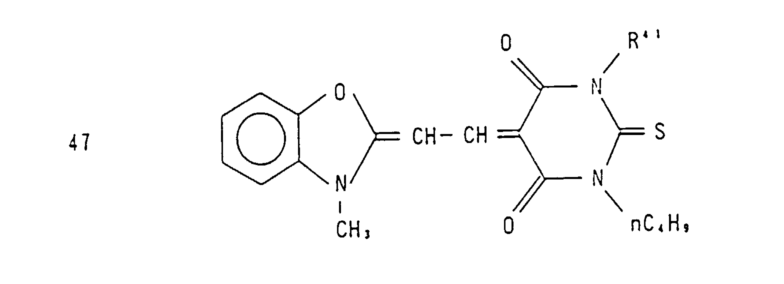

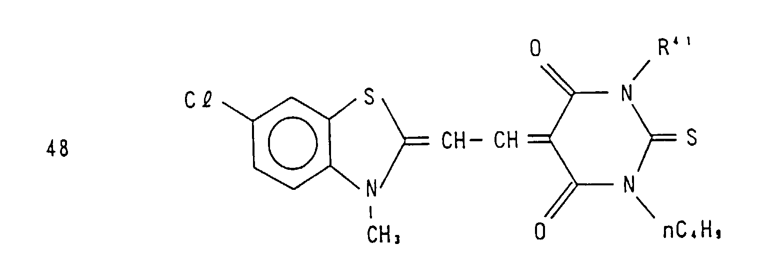

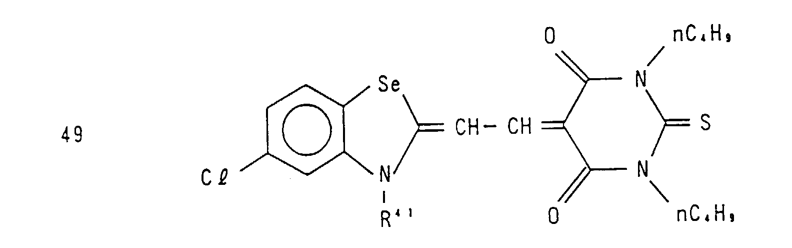

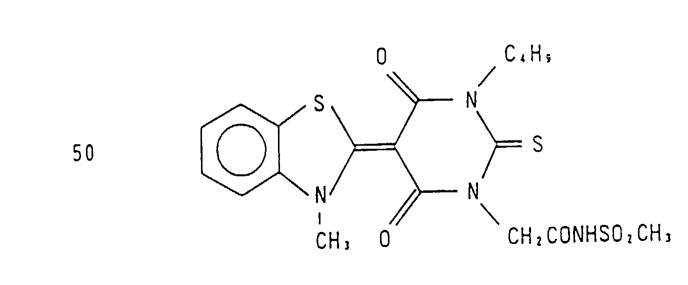

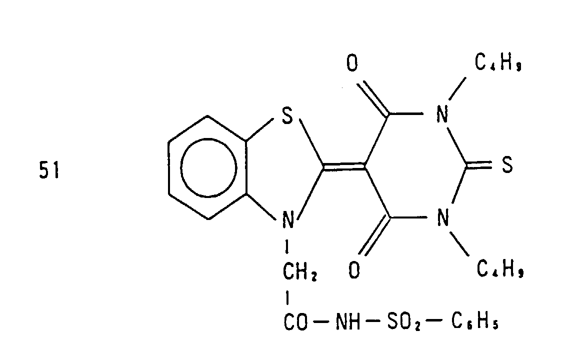

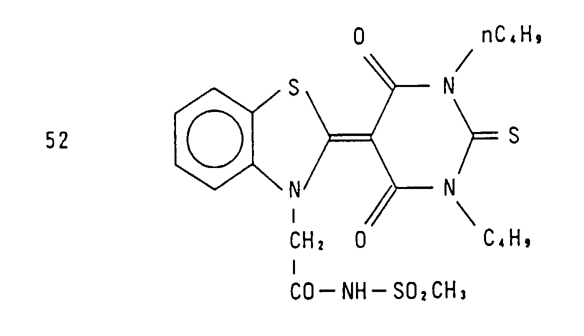

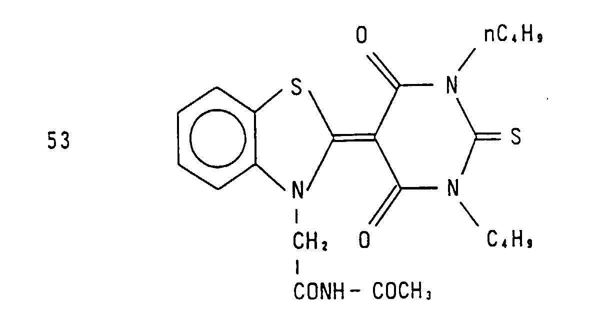

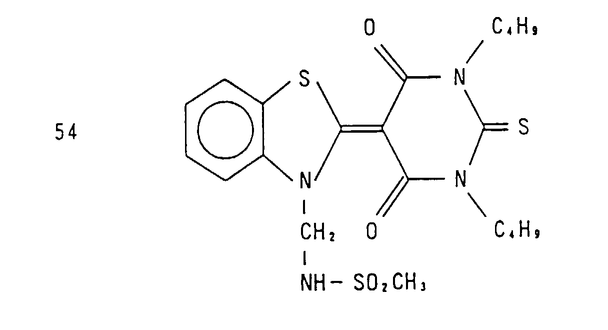

Among these compounds, compounds 1-22 are preferable because the starting materials therefor are readily available and these compounds provide an excellent sensitivity.

The sensitizer having the formula (I) is used in an amount of 1-30 wt.%, preferably 2-20 wt.% based on the total weight of the photosensitive composition.

The photosensitive composition of the present invention may also contain the other sensitizer than the sensitizer having the formula (I). In this case, the other sensitizer is selected so that when it is used together with the sensitizer having the formula (I), the photo-crosslinking rate is further improved. The other sensitizer includes benzoin, benzoin methylether, benzoin ethylether, 2,2-dimethoxy-2-phenylacetophenone, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, dibenzalacetone, p-(dimethylamino)phenylstyrylketone, p-(dimethylamino)phenyl-p-methylstyrylketone, benzophenone, p-(dimethylamino)benzophenone (Michler's ketone), p-(diethylamino) benzophenone and benzanthrone.

Further, thioxanthone derivatives (e.g., 2-chlorothioxanthone, 2-isopropylthioxanthone and dimethylthioxanthone) and substituted thioxanthones as disclosed in, for example, German Patent Nos. 3018891 and 3117568, European Patent No. 33720 and GB Patent No. 2075506 are preferably used. The other sensitizer is preferably used in an amount of 0.5-20 wt.%, much preferably 3-10 wt.% based on the total weight of the photosensitive composition.

In addition to the photo-crosslinkable polymer and the sensitizer, the photosensitive composition of the present invention may contain a negative-working diazo resin. if necessary. Such diazo resin may be a reaction product obtained by reacting a condensate with an anion, the condensate being produced by condensating a diazo monomer with a condensation agent (e.g., formaldehyde, acetoaldehyde, propionaldehyde, butylaldehyde, isobutylaldehyde and benzaldehyde), at a ratio of 1:1 to 1:0.5. preferably 1:0.8 to 1:0.6, under the conventional condensation conditions. The diazo monomer includes, for example, 4-diazo-diphenylamine, 1-diazo-4-N,N-dimethylaminobenzene, 1-diazo-4-N,N-diethylaminobenzene, 1-diazo-4-N-ethyl-N-hydroxyethylaminobenzene, 1-diazo-4-N-methyl-N-hydroxyethylaminobenzene, 1-diazo-2,5-dimethoxy-4-benzoylaminobenzene, 1-diazo-4-N-benzylaminobenzene, 1-diazo-4-N,N-dimethylaminobenzene, 1-diazo-4-morpholinobenzene, 1-diazo-2,5-dinethoxy-4-p-tolylmercaptobenzene, 1-diazo-2-ethoxy-4-N,N-dimethylaminobenzene, p-diazo-dimethylaniline, 1-diazo-2,5-dibutoxy-4-morpholinobenzene, 1-diazo-2,5-dimethoxy-4-morpholinobenzene, 1-diazo-2,5-diethoxy-4-morpholinobenzene, 1-diazo-2,5-diethoxy-4--p-tolylmercaptobenzene, 1-diazo-3-ethoxy-4-N-methyl-N-benzylaminobenzene, 1-diazo-3-chloro-4-N,N-diethylaminobenzene, 1-diazo-3-methyl-4-pyrrolidinobenzene, 1-diazo-2-chloro-4-N,N-dimethylamino-5-methoxybenzene, 1-diazo-3-methoxy-4-pyrrolidinobenzene, 3-methoxy-4-diazodiphenylamine, 3-ethoxy-4-diazodiphenylamine, 3-(n-propoxy)-4-diazodiphenylamine, and 3-(isopropoxy)-4-diazodiphenylamine.

The anion includes, for example, tetrafluoroboric acid, hexafluorophosphoric acid, triisopropyl naphthalenesulfonic acid, 5-nitro-o-toluenesulfonic acid, 5-sulfosalicylic acid, 2,5-dimethylbenzenesulfonic acid, 2,4,6-trimethylbenzenesulfonic acid, 2-nitrobenzenesulfonic acid, 3-chlorobenzenesulfonic acid, 3-bromobenzenesulfonic acid, 2-fluorocaprylnaphthalenesulfonic acid, dodecylbenzenesulfonic acid, 1-naphthol-5-sulfonic acid, 2-methoxy-4-hydroxy-5-benzoly-benzenesulfonic acid, and p-toluenesulfonic acid. In particular, hexafluorophosphoric acid and an alkyl aromatic sulfonic acid such as triisopropylnaphthalenesulfonic acid and 2,5-dimethylbenzenesulfonic acid are preferably used.

Further, the reaction product between a condensate of the above diazo monomer and an aldehyde having a carboxylic acid and/or phenol or an acetal thereof (if necessary, with the above condensation agent), and the above anion, as well as the diazo resins as disclosed in J.P. Kokai Nos. Hei 1-102456 and 1-102457, are also preferably used as a diazo resin in the present photosensitive composition.

The diazo resin is used generally in an amount of 0.1-15 wt.%, preferably 0.3-5 wt.% based on the total weight of the photosensitive composition.

The diazo resin can be used in a middle layer between a photosensitive layer and a support.

In addition to the photo-crosslinkable polymer, the photosensitive composition of the present invention may contain a known alkaline-soluble polymer such as phenol-formaldehyde resin, cresolformaldehyde resin, phenol-modified xylene resin, polyhydroxy styrene, polyhalogenated hydroxystyrene, carboxylic acid-containing (meth) acrylate resin, and carboxylic acid-containing polyurethane. Such alkaline-soluble polymer is used in an amount of up tp 70 wt.% based on the total weight of the photosensitive composition of the present invention.

It is preferably that the photosensitive composition of the present invention contain a heat polymerization inhibitor. Useful inhibitor includes hydroquinone, p-methoxyphenol, di-t-butyl-p-cresol, pyrogallol, t-butyl catechol. benzoquinone, 4,4'-thiobis(3-methyl-6-t-butylphenol), 2,2'-methylenebis(4-methyl-6-t-butylphenol), and 2-mercaptobenzimidazole.

The photosensitive composition of the present invention may also include a dye or a pigment for the purposes of coloring the photosensitive layer and a pH indicator as a printing-out agent. The printing-out agent includes a combination of a photosensitive compound which releases an acid when exposed and an organic dye, as a representative printing-put agent.

The photosensitive composition of the present invention may further include, as a stabilizer for the diazo resin, phosphoric acid. phosphorous acid, tartaric acid, citric acid, malic acid, dipicolinic acid, polynuclear aromatic sulfonic acid or salts thereof, sulfosalicylic acid, and phenylphosphonic acid.

The phtosensitive composition of the present invention may further contain a plasticizer such as dialkylphthalates (e.g., dibutylphthalate and dihexylphthalate), oligoethyleneglycolalkylesters and phosphate esters.

The photosensitive composition of the present invention is dissolved in a suitable sovent such as 2-methoxyethanol, 2-methoxyethylacetate, propyleneglycol monomethylether, 3-methoxypropanol, 3-methoxypropyl acetate, methylethyl ketone, N,N-dimethylformamide, N,N-dimethylacetoamide, dimethylsufoxide, ethylenedichloride, methyl lactate, ethyl lactate, methanol and water, and then coated onto a support. The solvent is used singly or as a combination thereof. The coating amount of the photosensitive composition of the present invention is generally, about 0.1-10g/m, preferably 0.5-5 g/m, on a dry basis.

The support usable for preparing a lithographic printing plate (PS plate) using the present photosensitive composition is preferably an aluminum plate. The aluminum plate includes those plates which are constituted of pure aluminum or its alloy. Various aluminum alloys can be empolyed. Such aluminum alloys include those alloys with a metal such as silicon, copper, manganese, magnesium, chromium, zinc, lead, bismuth and nickel. The aluminum alloy may contain some amounts of iron and titanium as well as a trace amount of impurities.

The aluminum plate may be surface-treated, if necessary. The surface-treatment preferably includes graining, immersion treatment with an aqueous solution of sodium silicate, potassium fluorozirconate and phosphate, or anodization. It is preferable that the aluminum plate be grained and then immersed in an aqueous sodium silicate solution as described in U.S. Patent No. 2,714,066 or the aluminum plate be anodized and then immersed in an aqueous solution of an alkali metal silicate as described in U.S. Patent No. 3,181,461. The anodization can be carried out by electrolyzing the aluminum plate used as an anode in an aqueous solution or non-aqueous solution of an inorganic acid such as phosphoric acid, chromic acid, sylfuric acid and boric acid or of an organic acid such as oxalic acid and sulfamic acid or the salts thereof. The aqueous solution or non-aqueous solution is used singly or as a combination thereof.

The silicate electrodeposition as described in U.S. Patent No. 3, 658,662 is also useful.

These hydrophilization treatments are carried out, not only for the purposes of making the surface of the support hydrophilic, but also for the purposes of preventing the adverse reaction with the photosensitive composition and of improving the close adhesion between the photosensitive layer and the support.

The aluminum plate may be subjected to pre-treatment before the graining, in order to remove grease on the surface and to produce clean aluminum surface. The pre-treatment for the former purpose is usually to use a solvent such as trichloroethylene and surfactants. The pre-treatment for the latter purpose is usually to use an alkaline etching agent such as sodium hydroxide and potassium hydroxide.

Any graining can be used whether it is mechanical graining, chemical graining or electrochemical graining. The mechanical graining includes ball graining, blast graining, and brush graining wherein the plate is brushed with a nylon brush using an aqueous dispersion slurry of an abrasive such as pumice. The chamical graining includes an immersion method as described in J.P. Kokai No. Sho 54-31187, wherein the plate is immersed in a saturated aqueous solution of aluminum salts such as those salts of mineral acids. The electrochemical graining includes an electrolysis method using an alternating current using an acidic eletrolyte solution such as hydrochloric acid, nitric acid or a combination thereof. In particular, a combined graining method of the mechamical graining and the electrochemical graining as described in J.P. Kokai No. Sho 55-137993 is preferable because it provides strong adhesion of an ink-receiving image area to the support.

It is preferable that the graining be carried out so that the center-line average roughness (Ra) is 0.3-1.0 µm.

The resultant aluminum plate may be washed with water and chemically etched, if necessary. The etching solution is usually selected from a basic and acidic aqueous solutions capable of dissolving aluminum. In this case, the etching solution must be those which produce a coating which is derived from the etching solution component and is different from aluminum. Preferred etching agent includes a basic material such as sodium hydroxide, potassium hydroxide, trisodium phosphate, disodium phosphate, tripotassium phosphate and dipotassium phosphate, and an acidic material such as sulfuric acid, persulfuric acid, phosphoric acid, hydrochloric acid and the salts thereof. The salts of a metal which has a lower ionization tendency than aluminum (e.g., zinc, chromium, cobalt, nickel and copper) are not suitable because they produce an unnecessary coating on the etched surface.

The concentration of the etching agent and the temperature at which the etching is carried out are preferably such that the dissolving rate of aluminum or an alloy is 0.3-40g/m per 1 minute immersion. However, the concentration and temperture outside these ranges can be employed.

The etching can be carried out by immersing the aluminum plate in the above etching solution or by coating the etching solution on the aluminum plate. The etched amount is preferably 0.5-10g/m.

It is preferable that a basic aqueous solution be used because it provides a high etching speed. In this case, however, smut is produced. Accordingly, a de-smutting treatment is necessary. The acid used in the de-smutting treatment includes nitric acid, sulfuric acid, phosphoric acid, chromic acid, hydrofluoric acid and borofluoric acid.

The resultant etched aluminum plate may be washed with water and anodized. The anodization can be carried out in a conventional manner. More specifically, the anodization can be carried out by passing electricity through the aluminum plate with direct current or alternating current in an aqueous or non-aqueous solution such as sulfuric acid, phosphoric acid, chromic acid, oxalic acid, sulfamic acid and benzenesulfonic acid, to form an anodically oxidized coating on the aluminum plate. The aqueous or non-aqueous solution can be used singly or as a combination thereof. The anodization conditions vary depending on the electrolyte solution used. In general, it is preferable that the electrolyte concentration be 1-80 wt.%, the liquid temperture 5-70°C the current density 0.5-60A/dm, the voltage 1-100V, and the electrolysis time 30 sec. to 50 min.

As an anodization, are preferable a process as described in GB Patent No. 1,412,768 wherein the anodization is carried out in sulfuric acid with a high current density and a process as described in U.S. Patent No. 3,511,661 wherein the anodization is carried out using phosphoric acid as an electrolyte bath.

The aluminum plate which has been grained and anodized, may be hydrophilized. The preferred hydrophilization includes the treatments with alkali metal silicates such as a sodium silicate aqueous solution as described in U.S. Patent Nos. 2,714,066 and 3,181,461, with potassium fluorozirconate as described in Japanese Patent Publication for Opposition Purposes (hereinafter referred to as "J.P. Kokoku") No. Sho 36-22063, and with polyvinylsulfonic acid as described in U.S. PatentNo. 4,153,461.

The aluminum plate may be further primed with an aqueous solution of resins such as polyacrylic acid or a polymer or copolymer having a sulfonic acid group in a side chain, a lower molecular weight compound soluble in an alkaline aqueous solution, triethanol amine salts, and an alanine compound.

The photosensitive composition coated on the aluminum support is exposed through a transparent original having line images or halftone dots.

The exposed PS plate is then developed with an aqueous alkaline developing solution, which includes a developing solution containing benzyl alcohol, an anionic surfactant, an alkali agent and water as described in J. P. Kokai No. Sho 51-77401, an aqueous developing solution containing benzyl alcohol, an anionic surfactant and a water-soluble sulfite as described in J.P. Kokai No. Sho 53-44202, and a developing solution containing an organic solvent whose solubility to water is 10 wt.% or less at room temperature, an alkali agent and water as described in J.P. Kokai No. Sho 55-155355.

These developing solutions contain an organic solvent. However, the organic solvent has many defects, for example, in that it is generally toxic and malodorous and is in danger of fire and that the BOD restriction is applied to it as waste. Further, the organic solvent is expensive. Accordingly, it is preferably that a developing solution containing substantially no organic solvent be used.

The expression "containing substantially no organic solvent" in the specification means that the organic solvent occupies 3 wt.% or less, preferably 1 wt.% or less, much preferably 0.5 wt.% or less, in the developing solution, in view of safty. The developing solution containing no organic solvent is most preferable.

The alkali agent used in the developing solution includes organic amines such as monoethanolamine, diethanolamine and triethanolamine, KOH, NaOH, potassium silicate, sodium silicate, sodium carbonate, potassium carbonate, sodium bicarbonate, potassium bicarbonate, Na or K salt of organic carboxylic acids, Na or K salt of phosphoric acid (primary, secondary or tertiary phosphate), and Na or K salt of boric acid (primary, secondary or tertiary borate).

The alkali agent is used in an amount of 10 wt.% or less based on the developing solution.

The developing solution may contain surfactants such as anionic surfactants as described in J.P. Kokai No. Sho 50-51324, amphoteric surfactants, and nonionic surfactants as described in J.P. Kokai Nos. Sho 59-75255 and 60-111246. The surfactant is used in an amount of 10 wt.% or less, preferably 6 wt.% or less based on the developing solution.

The developing solution may further contain a water-soluble sulfite such as sodium sulfite. The sulfite is used in an amount of 5 wt.% or less based on the developing solution.

### Effect of The Invention

The sensitizer having the formula (I) has a high solubility to a developing solution containing substantailly no organic solvent. Accordingly, a photosensitive composition containing such sensitizer has a high solubility to such developing solution. Since a photosensitive lithographic printing plate using the photosensitive composition of the present invention can be developed with such developing solution contianing substantailly no organic solvent without precipitating insolubles therein, the malfunction of an autodeveloper can be prevented and it is not necessary to often exchange the developing solution.

### Examples

The present invention will be more specifically explained by referring to the following examples.

### Synthetic Example 1

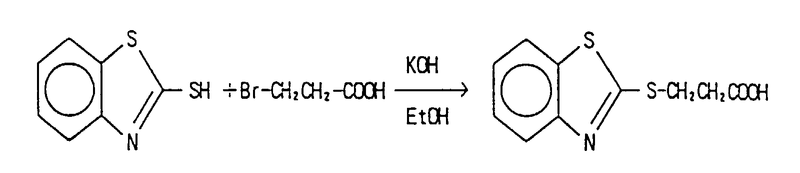

80g of 2-mercaptobenzothiazole and 150g of bromopropionic acid were added to 300ml of ethanol. 120g of KOH was slowly added to the mixture and stirred for 2 hr. Then, 500ml of water and then HCl were added to neutralize the mixture. The precipitated crystal was collected by filtration and washed with water, to yield 120g of crystal.

Melting point: 154-156°C

| Elemental Analysis (%) (Mw=239.3): | | | |
|---|---|---|---|
| Experimental value: | C 50.0 | H 4.0 | N 6.1 |
| Calculated value: | C 50.1 | H 3.8 | N 5.9 |

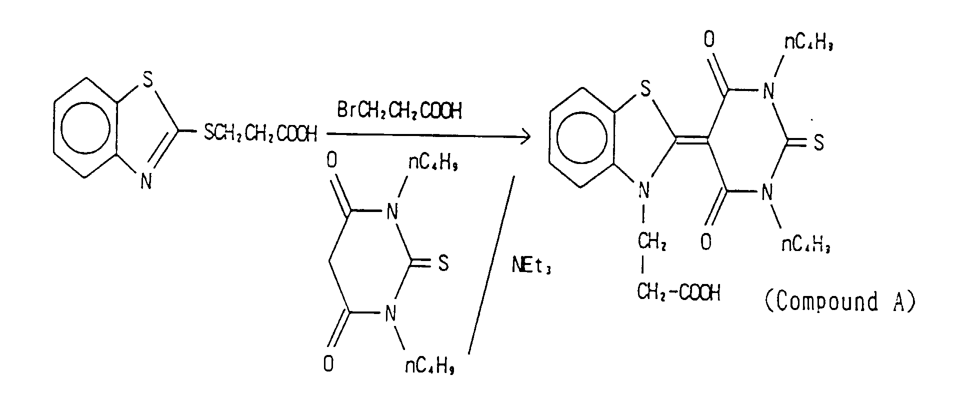

24g of 2-carboxyethylthiobenzothiazole and 31g of bromopropionic acid were heated at 120°C for 6 hr. After the reaction mixture was cooled, 200ml of THF and 30g of 1,3-dibutylthiobarbituric acid were added to the reaction mixture and further 80ml of triethylamine was added thereto and stirred. After the reaction was completed, the reaction mixture was poured into 300ml of water, which was neutralized with 100ml of HCl. The precipitated crystal was collected by filtration and washed with ethanol. to yield 17g of crystal (compound A).

Melting point: 190-192°C

| Elemental Analysis (%) (Mw=461.6): | | | |
|---|---|---|---|
| Experimental value: | C 57.4 | H 6.0 | N 8.8 |
| Calculated value: | C 57.2 | H 5.8 | N 9.1 |

### Synthetic Example 2

In the same manner as Synthetic Example 1, compound B having the following formula was produced.

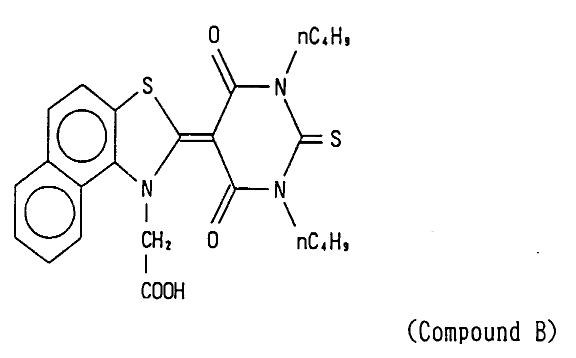

### Synthetic Example 3

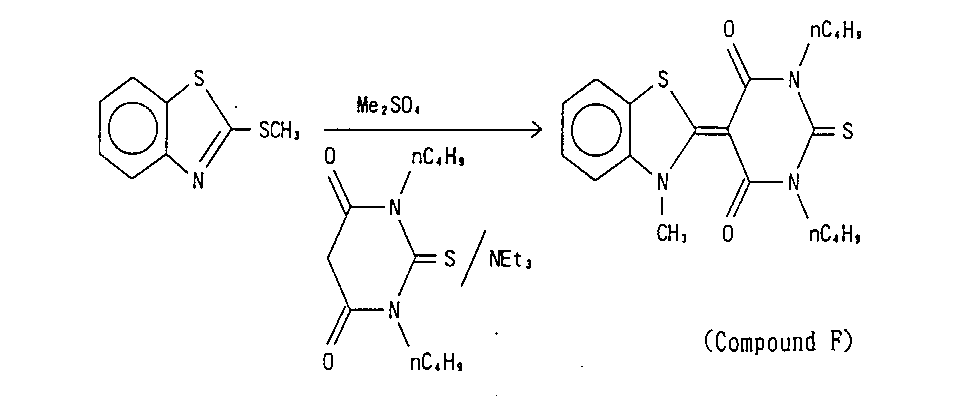

40g of 2-methythiolbenzothiazole and 30g of dimethyl sulfate were heated at 120 °C for 6 hr. After the reaction liquid was cooled. 200ml of THF and 60g of 1, 3-dibutylthiobarbituric acid were added to the reaction liquid and further 150ml of triethylamine was added thereto and stirred. After the reaction was completed, the reaction mixture was poured into 300ml of water. The precipitated crystal was collected by filtration and washed with ethanol, to yield 29g of crystal (compound F).

Melting point: 148-150°C

| Elemental Analysis (%) (Mw=403.6): | | | |
|---|---|---|---|
| Experimental value: | C 59.8 | H 6.3 | N 10.2 |
| Calculated value: | C 59.5 | H 6.2 | N 10.4 |

### Synthetic Examples 4-8

In the same manner as Synthetic Example 3, the following compounds C-E, G and H were prepared.

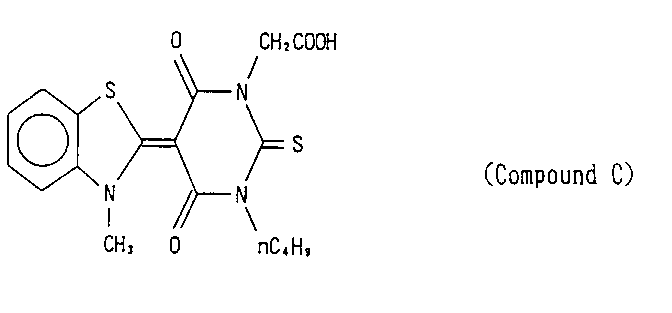

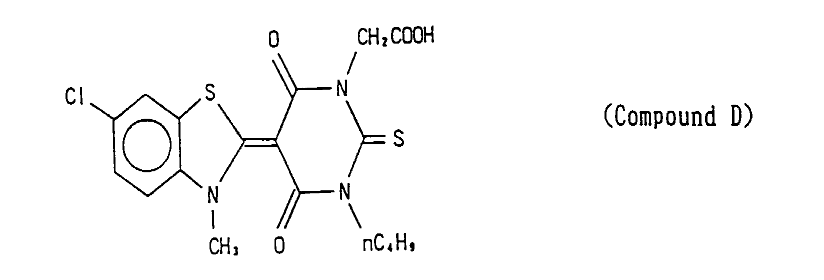

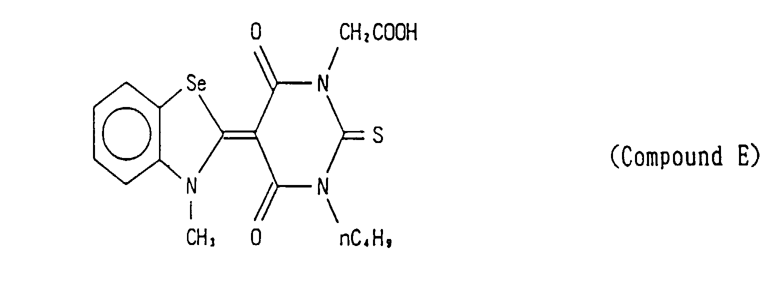

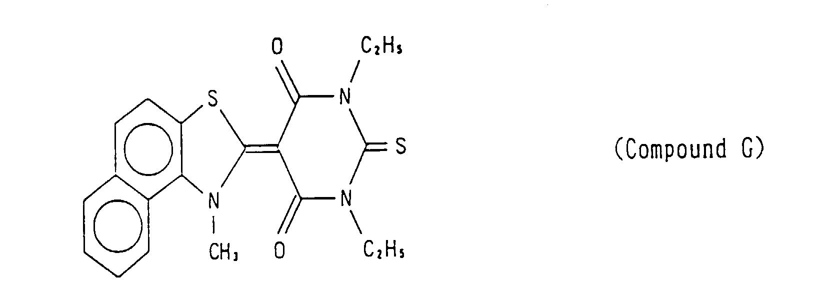

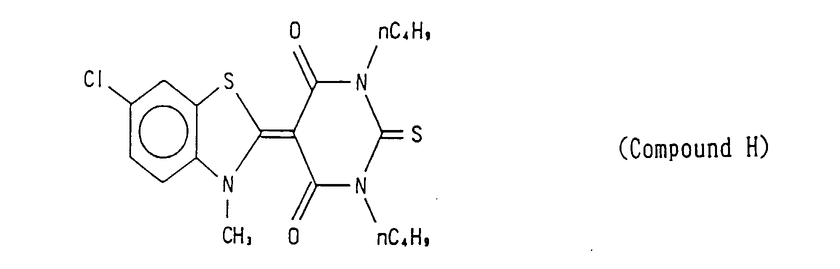

### Examples 1-5 and Comparative Examples 1-3

The solubility of Compounds A, B, C. D and E to the developing solutions (I) and (II) containing substantially no organic solvent was determined. In this case, 0.05g of the sensitizer was added to 50cc of the developing solution. The results are shown in Table 1 below.

As control, the solubility of Compounds F, G and H was determined in the same manner as above.

### Developing Solution (I):

| | |
|---|---|
| Potassium silicate having an SiO₂/K₂O molar ratio of about 1.2 | 32.3g |
| Water | 967.7g |

### Developing Solution (II):

| | |
|---|---|
| Potassium silicate having an SiO₂/K₂O molar ratio of about 0.78 | 57.0g |
| Water | 943.0g |

**Table 1**

| | Sensitizer | Developing Solution (I) | Developing Solution (II) |
|---|---|---|---|
| Example 1 | Compound A | Soluble | Soluble |
| Example 2 | Compound B | Soluble | Soluble |
| Example 3 | Compound C | Soluble | Soluble |
| Example 4 | Compound D | Soluble | Soluble |
| Example 5 | Compound E | Soluble | Soluble |
| Comp. Ex. ∗1 | Compound F | Difficult to Be Soluble | Difficult to Be Soluble |
| Comp. Ex. ∗2 | Compound G | Difficult to Be Soluble | Difficult to Be Soluble |
| Comp. Ex. ∗3 | Compound H | Difficult to Be Soluble | Difficult to Be Soluble |
| Note: Comp. Ex. means Comparative Example. | | | |

The table shows that the sensitizers having the formula (I) (Examples 1-5) have a higher solubility than those of Comparative Examples 1-3.

### Examples 6-10 and Comparative Examples 4-6

An aluminum plate having a thickness of 0.30mm was grained with a nylon brush and an aqueous suspension of pumice powder of 400 mesh, and then intensively washed with water. The plate was etched by immersing it in a 10% NaOH solution at 70 °C for 60 sec., washed with running water, neutralized with 20% HNO₃, and then wahsed with water. The plate was electrolytically grained in a 1% nitric acid aqueous solution using alternating sinusoidal current under the conditions of 12.7V of anodic voltage such that the quantity of electricity at the anode time was 160 coulomb/dm. The surface roughness was determined 0. 6µm (Ra indication). The plate was immersed and de-smutted in a 30% H₂SO₄ aqueous solution at 55°C for 2min. Then, the plate was anodized for 5 min. in a 20% H₃PO₄ aqueous solution with a current density of 2A/dm, so that the anodization oxidation coating had a thickness of 1.2g/m. The resultant plate was immersed in a 2.5% sodium silicate aqueous solution at 70 °C, washed with water and then dried.

The photosensitive liquid (I) having the following composition was coated on the resultant aluminum plate using a whirler, and then dried at 100°C for 2 min., to produce a photosensitive lithographic printing plate wherein a photosensitive layer had a thickness of 1g/m.

### Photosensitive Liquid (I):

| | gram |
|---|---|
| Methylmethacrylate/N-[6-(methacryloyoxy)hexyl]-2,3-dimethylmaleinimide/methacrylic acid=10/60/30 (molar ratio) (M_{w} =8.0×10⁴) | 5 |
| Sensitizer (Compounds A-H) | 0.5 |
| PF₆ salt of 4-diazodiphenyl amine (diazo monomer) | 0.03 |
| FC-430 (Fluoride type surfactant manufactured by US 3M Company) | 0.05 |
| 1-Methoxy-2-propanol | 100 |

2m of the photosensitive lithographic printing plate was developed with 100cc of each of the above developing solutions (I) and (II). The conditions of these developing solutions were observed on the 4 th day. The results are shown in Table 2 below.

**Table 2**

| (Photosensitive Liquid I) | | | |
|---|---|---|---|
| | Sensitizer | Developing Solution (I) | Developing Solution (II) |
| Example 6 | Compound A | No insolubles | No insolubles |
| Example 7 | Compound B | No insolubles | No insolubles |
| Example 8 | Compound C | No insolubles | No insolubles |
| Example 9 | Compound D | No insolubles | No insolubles |
| Example 10 | Compound E | No insolubles | No insolubles |
| | | | |
| Comp. Ex. ∗4 | Compound F | Insolubles | Insolubles |
| Comp. Ex. ∗5 | Compound G | Insolubles | Insolubles |
| Comp. Ex. ∗6 | Compound H | Insolubles | Insolubles |
| Note: Comp. Ex. means Comparative Example. | | | |

### Examples 11-15 and Comparative Examples 7-9

Examples 6-10 and Comparative Examples 4-6 were repeated except that the following photosensitive liquid II was used. The results are shown in Table 3 below.

### Photosensitive Liquid (II):

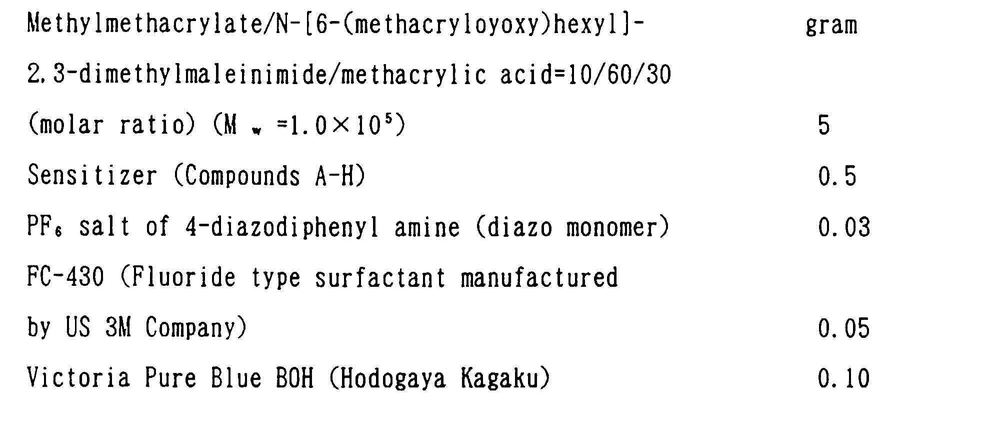

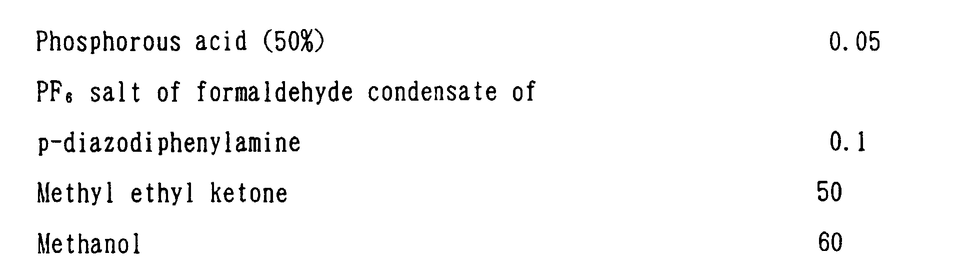

**Table 3**

| (Photosensitive Liquid II) | | | |
|---|---|---|---|
| | Sensitizer | Developing Solution (I) | Developing Solution (II) |
| Example 11 | Compound A | No insolubles | No insolubles |
| Example 12 | Compound B | No insolubles | No insolubles |
| Example 13 | Compound C | No insolubles | No insolubles |
| Example 14 | Compound D | No insolubles | No insolubles |
| Example 15 | Compound E | No insolubles | No insolubles |
| | | | |
| Comp. Ex. ∗7 | Compound F | Insolubles | Insolubles |
| Comp. Ex. ∗8 | Compound G | Insolubles | Insolubles |
| Comp. Ex. ∗9 | Compound H | Insolubles | Insolubles |
| Note: Comp. Ex. means Comparative Example. | | | |

### Examples 16-20 and Comparative Examples 10-12

Examples 6-10 and Comparative Examples 4-6 were repeated except that the following photosensitive liquid III was used. The results are shown in Table 4 below.

### Photosensitive Liquid (III):

| N-[6-(methacryloyoxy)hexyl]-2,3-dimethylmaleinimide/methacrylic acid=70/30 | gram |
|---|---|
| (molar ratio) (M_{w} =8.0×10⁴) | 6 |
| Sensitizer (Compounds A-H) | 0.5 |
| PF₆ salt of 4-diazodiphenyl amine (diazo monomer) | 0.03 |
| Megafac F-177 (Fluoride type nonionic surfactant manufactured by Dainippon Ink Co., Ltd.) | 0.03 |
| Victoria Pure Blue BOH (Hodogaya Kagaku) | 0.10 |
| Phosphorous acid (50%) | 0.05 |
| Dodecybenzene sulfonate of formaldehyde condensate of 4-diazodiphenylamine and phenoxy acetic acid | 0.20 |
| Propyleneglycol monomethylether | 60 |
| Methyl ethyl ketone | 50 |

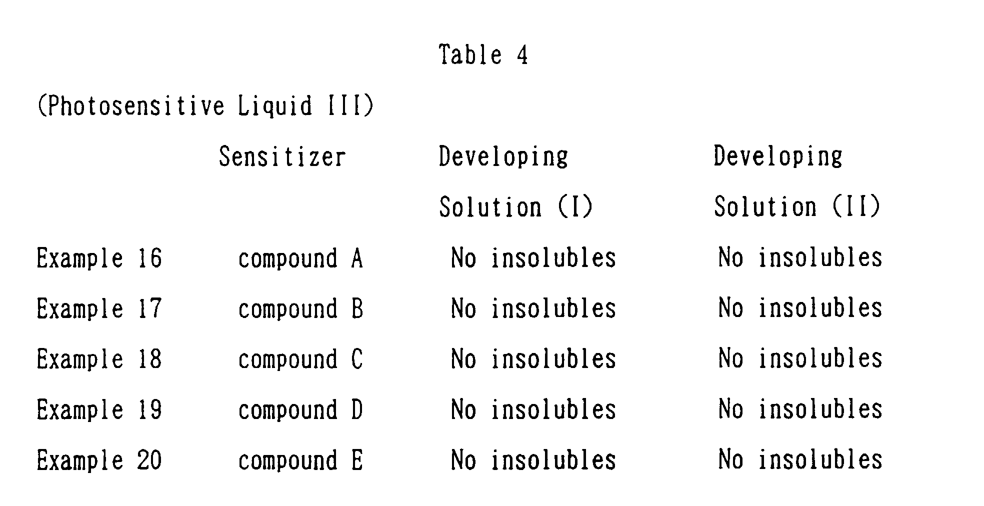

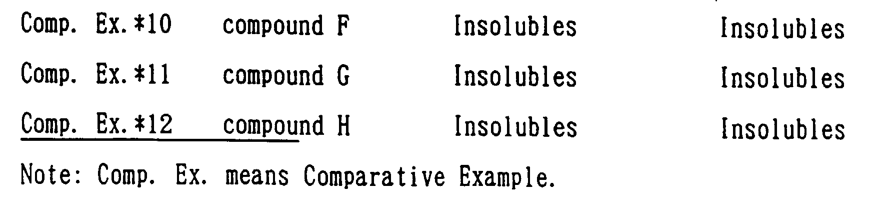

Tables 2-4 show that the photosensitive lithographic printing plate using the sensitizer having the formula (I) does not produce any insolubles in developing solutions containing no organic solvent when it is developed with them.

## Claims

1. A photosensitive composition comprising:
(a) a photo-crosslinkable polymer having a photo-dimerizable unsaturated double bond, and
(b) a sensitizer having the following formula (I): 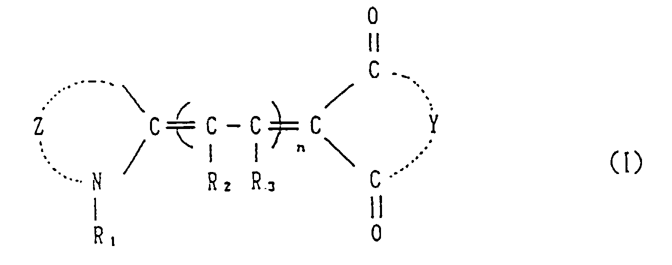 wherein
Z is a group of non-metal atoms necessary for forming a heterocyclic ring nucleus containing a nitrogen atom;
Y is a group of non-metal atoms necessary for forming a ring;
R₁ is an alkyl group or a substituted alkyl group;
R₂ and R₃ are independently a hydrogen atom, an alkyl group, a substituted alkyl group, an aryl group, a substituted aryl group, or a halogen atom;
at least one of Z, Y and R₁ contains at least one group selected from the group consisting of -COOH, -NHSO₂R₄, CONHCOR₄ and CONHSO₂R₄;
R₄ is an alkyl group, an aromatic group or an aromatic alkyl group; and
n is an integer of 0-4.

2. The photosensitive composition of claim 1 wherein said heterocyclic ring nucleus containing a nitrogen atom is selected from the group consisting of benzothiazoles, naphthothiazoles, benzoselenazoles. naphthoselenazoles, benzoxazoles, naphthoxazoles, imidazoles, isoindoles quinolines, diazoles, triazoles, pyrazines, quinoxalines, S-triazines, and phenanthridines.

3. The photosensitive composition of claim 1 wherein said ring formed by Y is selected from the group consisting of the rings having the following formulae: 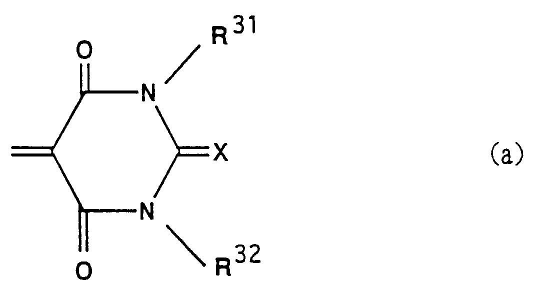 wherein
R³¹ and R ³ independently represent a hydrogen atom, an alkyl group, a substituted alkyl group, an aryl group, a substituted aryl group, an allyl group, or a substituted allyl group: and
X is an oxygen atom or a sulfur atom; 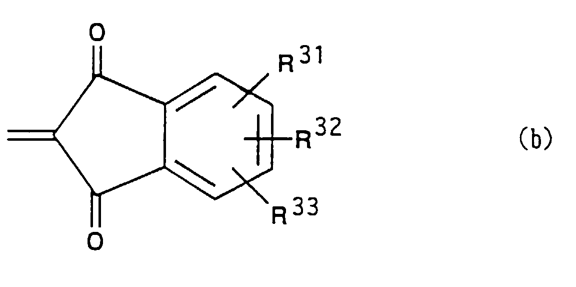 wherein
R³¹, R ³ and R³³ independently represent a hydrogen atom, an alkyl group, a substituted alkyl group, an aryl group, a substituted aryl group, an allyl group, a substituted allyl group, an alkoxy group, a substituted alkoxy group, a nitro group, a cyano group, an amino group, or a halogen atom; 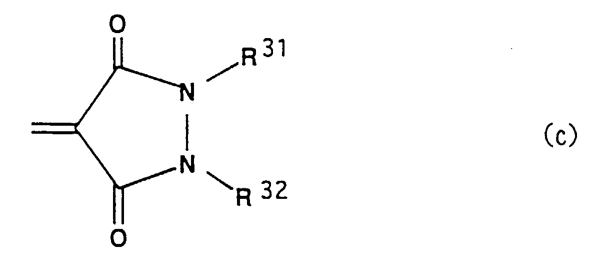 wherein
R³¹ and R ³ independently represent a hydrogen atom, an alkyl group, a substituted alkyl group, an aryl group, a substituted aryl group, an allyl group or a substituted allyl group; 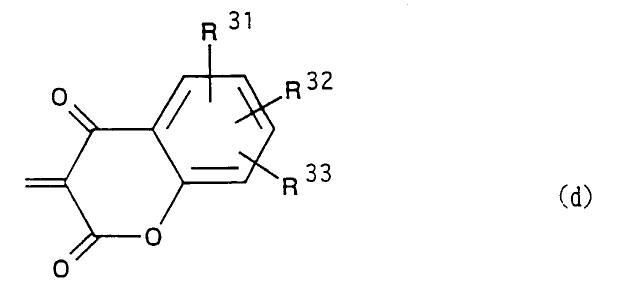 wherein
R³¹, R ³ and R³³ independently represent a hydrogen atom, an alkyl group, a substituted alkyl group, an aryl group, a substituted aryl group, an allyl group, a substituted allyl group, an alkoxy group, a substituted alkoxy group, a nitro group, a cyano group, an amino group, or a halogen atom; 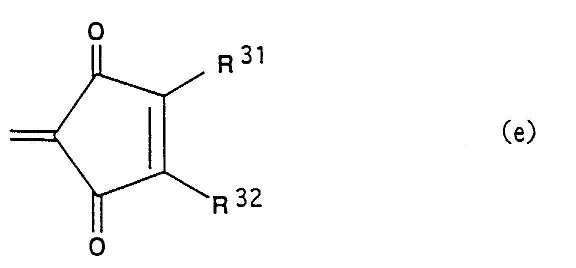 wherein
R³¹ and R ³ independently represent a hydrogen atom, an alkyl group, a substituted alkyl group, an aryl group and a substituted aryl group.

4. The photosensitive composition of claim 1 wherein said R₁ represents a saturated or unsaturated and linear or branched alkyl group having 1-20 carbon atoms or the substituted alkyl group thereof.

5. The photosensitive composition of claim 4 wherein said R₁ represents a methyl group, an ethyl group, a propyl group, a 2-hydroxyethyl group, a 2-methoxyethyl group, a carboxymethyl group, a 2-carboxyethyl group, a 3-carboxypropyl group, a 2-sulfoethyl group, a 3-sulfopropyl group, a 2-carbomethoxy group, a benzyl group, a phenethyl group, a p-sulfophenethyl group, a p-carboxyphenethyl group, a vinylmethyl group, a CH₂CONHSO₂CH₃ group, a CH₂CONHSO₂C₆H₅ group, a CH₂NHSO₂CH₃ group and a CH₂CONHCOCH₃ group.

6. The photosensitive composition of claim 1 wherein said R₂ and R₃ independently represent a hydrogen atom, an alkyl group, a substituted alkyl group, an aryl group, a substituted ary group or a halogen atom.

7. The photosensitive composition of claim 1 wherein said sensitizer is used in an amount of 1-30 wt.% based on the photosensitive composition.

8. The photosensitive composition of claim 1 wherein said photo-crosslinkable polymer is a photosensitive polymer containing a maleinimide group, a cinnamyl group, a cinnamoyl group, a cinnamylidene group or a chalcone group in a side chain or a main chain.

9. The photosensitive composition of claim 8 wherein said photo-crosslinkable polymer is a polymer having two or more maleinimide groups in a side chain per molecule on an average and having an average molecular weight of 1,000 to 1,000,000.

10. The photosensitive composition of claim 1 wherein said photo-crosslinkable polymer is used in an amount of 10-99 wt.% based on the photosensitive composition.

## Patentansprüche

1. Lichtempfindliche Zusammensetzung, umfassend
a) ein durch Licht vernetzbares Polymer mit einer lichtdimerisierbaren ungesättigten Doppelbindung und
b) ein Sensibilisierungsmittel der folgenden Formel (I): 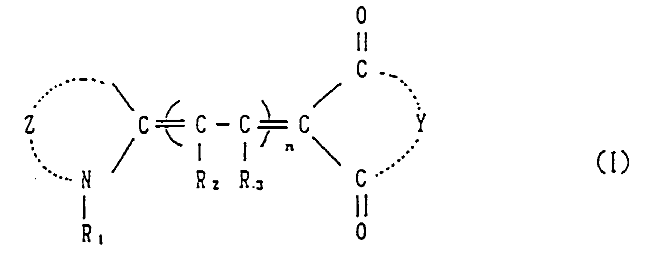 in der Z eine Gruppe von Nichtmetallatomen bedeutet, die zur Bildung eines heterocyclischen Rings, der ein Stickstoffatom enthält, notwendig sind, Y eine Gruppe von Nichtmetallatomen bedeutet, die zur Bildung eines Rings notwendig sind, R₁ einen Alkylrest oder einen substituierten Alkylrest bedeutet, R₂ und R₃ unabhängig voneinander ein Wasserstoffatom, einen Alkylrest, einen substituierten Alkylrest, einen Arylrest, einen substituierten Arylrest oder ein Halogenatom bedeuten, mindestens einer der Reste Z, Y und R₁ mindestens eine Gruppe enthält, die aus der Gruppe -COOH, -NHSO₂R₄, CONHCOR₄ und CONHSO₂R₄ ausgewählt ist, R₄ einen Alkylrest, einen aromatischen Rest oder einen aromatischen Alkylrest bedeutet und n eine ganze Zahl von 0 bis 4 bedeutet.

2. Lichtempfindliche Zusammensetzung nach Anspruch 1, wobei der heterocyclische Ring, der ein Stickstoffatom enthält, aus der Gruppe Benzothiazole, Naphthothiazole, Benzoselenazole, Naphthoselenanzole, Benzoxazole, Naphthoxazole, Imidazole, Isoindole, Chinoline, Diazole, Triazole, Pyrazine, Chinoxaline, S-Triazine und Phenanthridine ausgewählt ist.

3. Lichtempfindliche Zusammensetzung nach Anspruch 1, wobei der durch Y gebildete Ring aus der Gruppe der Ringe mit den folgenden Formeln: 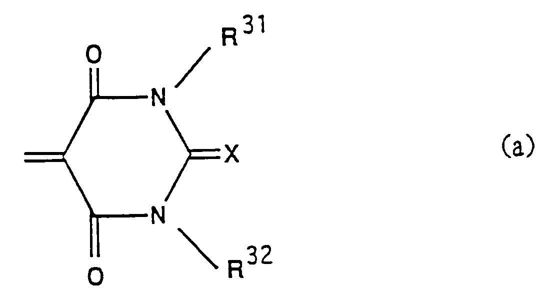 in der R₃₁ und R₃₂ unabhängig voneinander ein Wasserstoffatom, einen Alkylrest, einen substituierten Alkylrest, einen Arylrest, einen substituierten Arylrest, einen Allylrest oder einen substituierten Allylrest bedeuten und X ein Sauerstoff- oder Schwefelatom bedeutet, 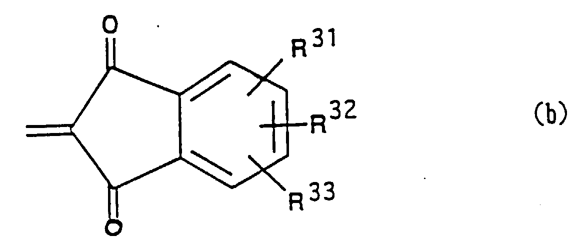 in der R₃₁, R₃₂ und R₃₃ unabhängig voneinander ein Wasserstoffatom, einen Alkylrest, einen substituierten Alkylrest, einen Arylrest, einen substituierten Arylrest, einen Allylrest, einen substituierten Allylrest, einen Alkoxyrest, einen substituierten Alkoxyrest, eine Nitrogruppe, eine Cyanogruppe, eine Aminogruppe oder ein Halogenatom bedeuten, 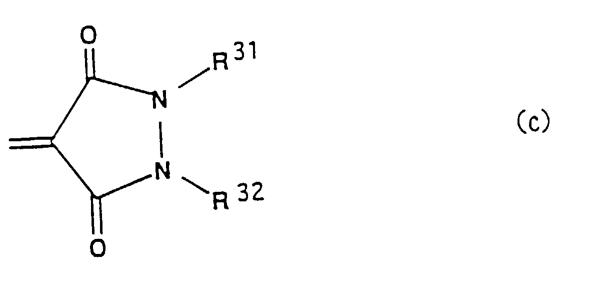 in der R₃₁ und R₃₂ unabhängig voneinander ein Wasserstoffatom, einen Alkylrest, einen substituierten Alkylrest, einen Arylrest, einen substituierten Arylrest, einen Allylrest oder einen substituierten Allylrest bedeuten, 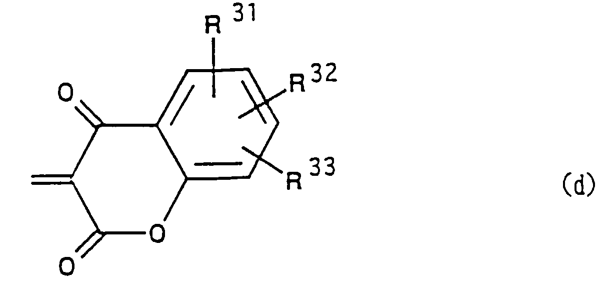 in der R₃₁, R₃₂ und R₃₃ unabhängig voneinander ein Wasserstoffatom, einen Alkylrest, einen substituierten Alkylrest, einen Arylrest, einen substituierten Arylrest, einen Allylrest, einen substituierten Allylrest, einen Alkoxyrest, einen substituierten Alkoxyrest, eine Nitrogruppe, eine Cyanogruppe, eine Aminogruppe oder ein Halogenatom bedeuten, 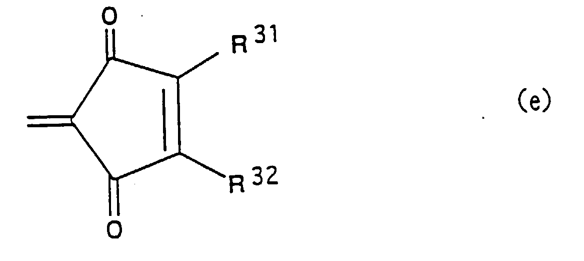 in der R₃₁ und R₃₂ unabhängig voneinander ein Wasserstoffatom, einen Alkylrest, einen substituierten Alkylrest, einen Arylrest und einen substituierten Arylrest bedeuten, ausgewählt ist.

4. Lichtempfindliche Zusammensetzung nach Anspruch 1, wobei R₁ einen gesättigten oder ungesättigten und geraden oder verzweigten Alkylrest mit 1 bis 20 Kohlenstoffatomen oder den substituierten Alkylrest davon bedeutet.

5. Lichtempfindliche Zusammensetzung nach Anspruch 4, wobei R₁ eine Methylgruppe, eine Ethylgruppe, eine Propylgruppe, eine 2-Hydroxyethylgruppe, eine 2-Methoxyethylgruppe, eine Carboxymethylgruppe, eine 2-Carboxymethylgruppe, eine 3-Carboxypropylgruppe, eine 2-Sulfoethylgruppe, eine 3-Sulfopropylgruppe, eine 2-Carbomethoxygruppe, eine Benzylgruppe, eine Phenethylgruppe, eine p-Sulfophenethylgruppe, eine p-Carboxyphenethylgruppe, eine Vinylmethylgruppe, eine CH₂CONHSO₂CH₃-Gruppe, eine CH₂CONHSO₂C₆H₅-Gruppe, eine CH₂NHSO₂CH₃-Gruppe und eine CH₂CONHCOCH₃-Gruppe bedeutet.

6. Lichtempfindliche Zusammensetzung nach Anspruch 1, wobei R₂ und R₃ unabhängig voneinander ein Wasserstoffatom, einen Alkylrest, einen substituierten Alkylrest, einen Arylrest, einen substituierten Arylrest oder ein Halogenatom bedeuten.

7. Lichtempfindliche Zusammensetzung nach Anspruch 1, wobei das Sensibilisierungsmittel in einer Menge von 1 bis 30 Gew.-%, bezogen auf die lichtempfindliche Zusammensetzung verwendet wird.

8. Lichtempfindliche Zusammensetzung nach Anspruch 1, wobei das durch Licht vernetzbare Polymer ein lichtempfindliches Polymer ist, das eine Maleinimidgruppe, eine Cinnamylgruppe, eine Cinnamoylgruppe, eine Cinnamylidengruppe oder eine Chalcongruppe in einer Neben- oder Hauptkette bedeutet.

9. Lichtempfindliche Zusammensetzung nach Anspruch 8, wobei das durch Licht vernetzbare Polymer ein Polymer ist, das im Durchschnitt zwei oder mehr Maleinimidgruppen pro Molekül in einer Seitenkette und ein durchschnittliches Molekulargewicht von 1000 bis 1000000 aufweist.

10. Lichtempfindliche Zusammensetzung nach Anspruch 1, wobei das durch Licht vernetzbare Polymer in einer Menge von 10 bis 99 Gew.-%, bezogen auf die lichtempfindliche Zusammensetzung verwendet wird.

## Revendications

1. Composition photosensible comprenant :
(a) un polymère photoréticulable ayant une double liaison insaturée photodimérisable, et
(b) un sensibilisant ayant la formule suivante (I) : 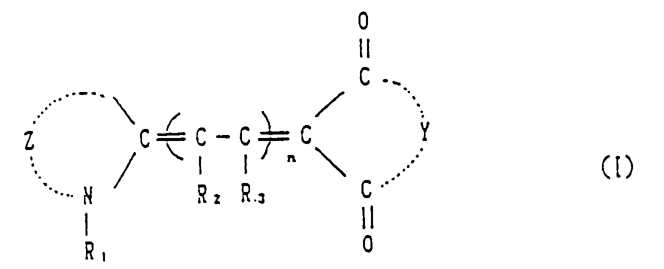 où
Z est un groupe d'atomes non métalliques nécessaires pour former un noyau hétérocyclique contenant un atome d'azote ;
Y est un groupe d'atomes non métalliques nécessaires pour former un cycle ;
R₁ est un groupe alkyle ou un groupe alkyle substitué ;
R₂ et R₃ représentent indépendamment un atome d'hydrogène, un groupe alkyle, un groupe alkyle substitué, un groupe aryle, un groupe aryle substitué ou un atome d'halogène ;
au moins l'un des groupes Z, Y et R₁ contient au moins un groupe choisi parmi le groupe constitué de -COOH, -NHSO₂R₄, CONHCOR₄ et CONHSO₂R₄ ;
R₄ est un groupe alkyle, un groupe aromatique ou un groupe alkyle aromatique ; et
n est un entier de 0 à 4.

2. Composition photosensible selon la revendication 1, où ledit noyau hétérocyclique contenant un atome d'azote est choisi dans le groupe constitué des benzothiazoles, naphtothiazoles, benzosélénazoles, naphtosélénazoles, benzoxazoles, naphtoxazoles, imidazoles, isoindoles, quinoléines, diazoles, triazoles, pyrazines, quinoxalines, S-triazines et phénanthridines.

3. Composition photosensible selon la revendication 1, où ledit cycle formé par Y est choisi dans le groupe constitué des cycles ayant les formules suivantes : 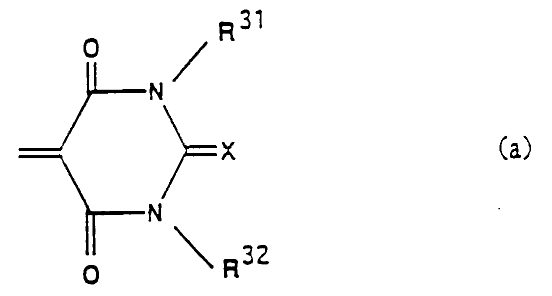 ou
R³¹ et R³ représentent indépendamment un atome d'hydrogène, un groupe alkyle, un groupe alkyle substitué, un groupe aryle, un groupe aryle substitué, un groupe allyle ou un groupe allyle substitué ; et
X est un atome d'oxygène ou un atome de soufre : 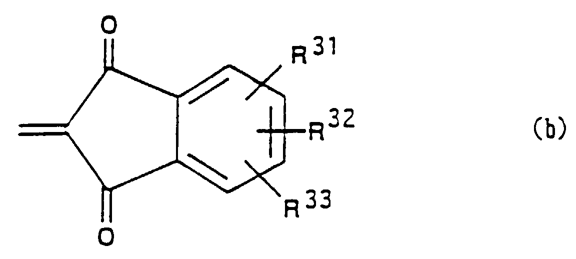 où
R³¹, R³ et R³³ représentent indépendamment un atome d'hydrogène, un groupe alkyle, un groupe alkyle substitué, un groupe aryle, un groupe aryle substitué, un groupe allyle, un groupe allyle substitué, un groupe alcoxy, un groupe alcoxy substitué, un groupe nitro, un groupe cyano, un groupe amino, ou un atome d'halogène ; 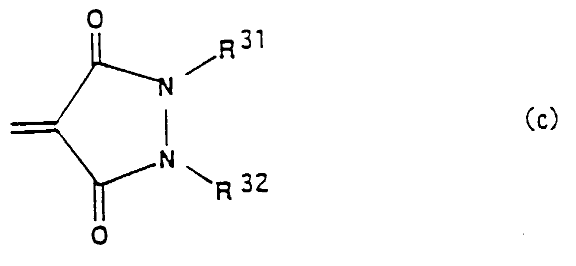 où
R³¹ et R³ représentent indépendamment un atome d'hydrogène, un groupe alkyle, un groupe alkyle substitué, un groupe aryle, un groupe aryle substitué, un groupe allyle ou un groupe allyle substitué ; 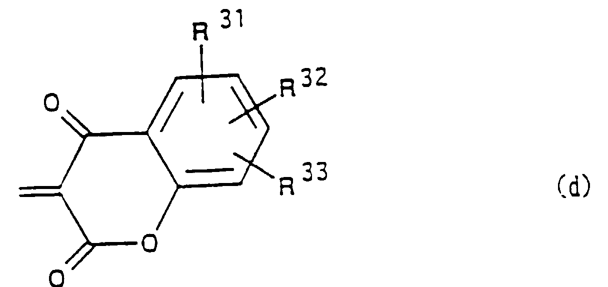 où
R³¹, R³ et R³³ représentent indépendamment un atome d'hydrogène, un groupe alkyle, un groupe alkyle substitué, un groupe aryle, un groupe aryle substitué, un groupe allyle, un groupe allyle substitué, un groupe alcoxy, un groupe alcoxy substitué, un groupe nitro, un groupe cyano, un groupe amino ou un atome d'halogène ; 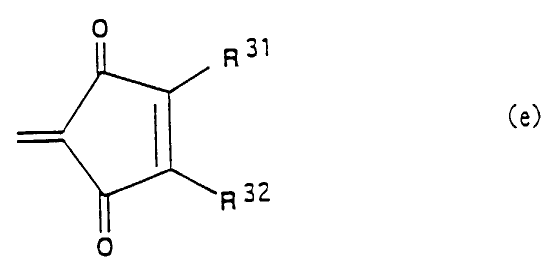 où
R³¹ et R³ représentent indépendamment un atome d'hydrogène, un groupe alkyle, un groupe alkyle substitué, un groupe aryle et un groupe aryle substitué.

4. Composition photosensible selon la revendication 1, où ledit groupe R₁ représente un groupe alkyle saturé ou insaturé linéaire ou ramifié ayant 1-20 atomes de carbone ou son groupe alkyle substitué.

5. Composition photosensible selon la revendication 4, où ledit groupe R₁ représente un groupe méthyle, un groupe éthyle, un groupe propyle, un groupe 2-hydroxyéthyle, un groupe 2-méthoxyéthyle, un groupe carboxyméthyle, un groupe 2-carboxyéthyle, un groupe 3-carboxypropyle, un groupe 2-sulfoéthyle, un groupe 3-sulfopropyle, un groupe 2-carbométhoxy, un groupe benzyle, un groupe phénéthyle, un groupe p-sulfophénéthyle, un groupe p-carboxyphénéthyle, un groupe vinylméthyle, un groupe CH₂CONHSO₂CH₃, un groupe CH₂CONHSO₂C₆H₅, un groupe CH₂NHSO₂CH₃ et un groupe CH₂CONHCOCH₃.

6. Composition photosensible selon la revendication 1, où lesdits groupes R₂ et R₃ représentent indépendamment un atome d'hydrogène, un groupe alkyle, un groupe alkyle substitué, un groupe aryle, un groupe aryle substitué ou un atome d'halogène.

7. Composition photosensible selon la revendication 1, où ledit sensibilisant est utilisé en une quantité de 1-30% en poids par rapport à la composition photosensible.

8. Composition photosensible selon la revendication 1, où ledit polymère photoréticulable est un polymère photosensible contenant un groupe maléinimide, un groupe cinnamyle, un groupe cinnamoyle, un groupe cinnamylidène ou un groupe chalcone dans la chaîne latérale ou dans la chaîne principale.

9. Composition photosensible selon la revendication 8, où ledit polymère photoréticulable est un polymère ayant deux ou plusieurs groupes maléinimide dans une chaîne latérale par molécule en moyenne et a un poids moléculaire moyen de 1 000 à 1 000 000.

10. Composition photosensible selon la revendication 1, où ledit polymère photoréticulable est utilisé en une quantité de 10-99% en poids par rapport à la composition photosensible.
